(19) Europäisches Patentamt / European Patent Office / Office européen des brevets

(11) **EP 2 570 252 B1**

(12) **EUROPEAN PATENT SPECIFICATION**

| | |
|---|---|
| (45) Date of publication and mention of the grant of the patent: **30.07.2014 Bulletin 2014/31** | (51) Int Cl.: **B29C 55/14** (2006.01) **H01L 31/048** (2014.01) |

(21) Application number: **12181184.8**

(22) Date of filing: **21.08.2012**

(54) **Method of manufacturing a biaxially stretched thermoplastic resin film**

Verfahren zur Herstellung eines biaxial gestreckten thermoplastischen Harzfilm

Procédé de fabrication d'un film de résine thermoplastique étiré biaxialement

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **16.09.2011 JP 2011203636**

(43) Date of publication of application:
**20.03.2013 Bulletin 2013/12**

(73) Proprietor: **FUJIFILM Corporation Tokyo 106-8620 (JP)**

(72) Inventor: **Sato, Takanori Kanagawa 258-8577 (JP)**

(74) Representative: **HOFFMANN EITLE Patent- und Rechtsanwälte Arabellastrasse 4 81925 München (DE)**

(56) References cited:
**EP-A1- 1 920 902        EP-A1- 2 163 572
WO-A1-2008/029666    WO-A1-2012/081500
US-A1- 2010 256 261**

**Description**

**BACKGROUND OF THE INVENTION**

1. Field of the Invention

The present specification relates to a biaxially stretched thermoplastic resin film, a method of manufacturing the same, a back sheet for a solar cell, and a solar cell module.

2. Description of the Related Art

As one of characteristics of a resin film, it is preferable that dimensional stability be excellent.

In recent years, a polyester film that is exemplified as a representative resin film has been applied to various uses such as an electrical insulation use and an optical use. As the electrical insulation use, particularly, application for a solar cell use such as a rear surface protective sheet (a so-called back sheet) of a solar cell has attracted attention.

In a polyester film that is used for a solar cell use, a film, which is not likely to be thermally contracted and which is excellent in a dimensional stability, has been also required.

As an example of improving the dimensional stability, a method in which thermal contraction is made to be small by loosening stretching tension both in a longitudinal direction and a transverse direction after a process of stretching a polyester film is disclosed (for example, refer to JP2004-130594A and JP2001-212919A). In addition, a method in which a relaxation treatment in a longitudinal direction is performed by making a clip distance narrow (for example, refer to JP2007-276190A and JP1994-023838A (JP-H06-023838A), a method in which a distance between clips that grip a film is expanded in a transverse direction and is reduced in a longitudinal direction (for example, refer to JP2010-240976A), and the like have been disclosed.

However, commonly, since carboxy groups or hydroxyl groups are present on a surface of polyester in a large amount, the polyester has a tendency to be hydrolyzed in an environment in which moisture is present, and has a tendency to deteriorate with the passage of time. An environment in which a solar cell module is generally used is an environment, which is always exposed to weather, such as outdoors, and in this environment, hydrolysis tends to easily occur. Therefore, in the case of applying polyester to a solar cell use, suppression of a hydrolysis property of polyester is one of important characteristics.

In regard to the above description, for example, to obtain polyester that is excellent in hydrolysis resistance, a method of manufacturing polyester by using a polyester polymerization catalyst, which contains aluminum and a compound thereof as a first metal-containing component and in which a phosphorus compound coexists, and a polyester film are disclosed (refer to WO2002/022707A).

US 2010/256261 A1 discloses a biaxially oriented, hydrolyses stable polyester film and a process for manufacturing said film.

**SUMMARY OF THE INVENTION**

However, in the method based on the above-description technology in the related art, only any one of the dimensional stability and the hydrolysis resistance may be solved and a technology of satisfying the dimensional stability and the hydrolysis resistance at the same time is not suggested yet.

The present invention has made in consideration of the above circumstances, and an object thereof is to provide a biaxially stretched thermoplastic resin film that is excellent both in dimensional stability and hydrolysis resistance, a method of manufacturing the biaxially stretched thermoplastic resin film, a back sheet for a solar cell, which is excellent in a durability performance over a long time, and a solar cell module that is capable of obtaining a stable power generation performance over a long time, and this object is a problem to be solved.

Specific means for accomplishing the above-described problem is as follows:

<1> According to a first aspect of the invention, there is provided a method of manufacturing a biaxially stretched thermoplastic resin film, the method including: performing melt extrusion of a thermoplastic resin into a sheet form and cooling the resultant sheet on a casting drum to form a thermoplastic resin sheet; longitudinally stretching the thermoplastic resin sheet, which is formed, in a longitudinal direction or a rolling direction of the casting drum; and gripping the thermoplastic resin sheet after the longitudinal stretching by a gripping member and transversely stretching the thermoplastic resin sheet in a transverse direction orthogonal to the longitudinal direction. The transverse stretching includes: preheating the thermoplastic resin sheet after the longitudinal stretching to a stretchable temperature; applying a tension to the thermoplastic resin sheet, which is preheated, in the transverse direction orthogonal to the longitudinal direction to transversely stretch the thermoplastic resin sheet; heating the thermoplastic resin film that is obtained by the longitudinal stretching and the transverse stretching to crystallize and thermally fix the thermoplastic resin film; relaxing the tension applied to the thermoplastic resin film that is thermally fixed to remove remaining strain; and cooling the thermoplastic resin film after the relaxing of the tension. At least one of the thermal fixing and the thermal relaxing performs contraction treatment of the thermoplastic resin film in the longitudinal direction of the film in such a manner that a contraction ratio expressed by the following Formula (1) is within a range of 3 to 8% while narrowing a grip distance between gripping members adjacent to each other, a total contraction treatment time in the thermal fixing and the thermal relaxing is 10 to 60 seconds, and an average rising rate of the film surface temperature from a termination point of time of the transverse stretching in the stretching process until the film surface temperature reaches a maximum arrival temperature in an interval in which the contraction treatment is performed so as to satisfy the contraction ratio is 0.6 to 4.5 °C/second.

$$[\{(A+B)-(C+B)\}/(A+B)]\times100 \cdots \text{Formula (1)}$$

In Formula (1), A represents a grip distance (mm) before narrowing the distance between the gripping members adjacent to each other, B represents the length (mm) of each of the gripping members in the longitudinal direction of the film, and C represents a grip distance (mm) after narrowing the distance between the gripping members adjacent to each other.

<2> The method of manufacturing a biaxially stretched thermoplastic resin film according to <1>, wherein the length B of the gripping member and the grip distance A before narrowing the distance between the gripping members adjacent to each other satisfy a relational formula expressed by the following Formula (2).

$$0.06 \leq A/(A+B) \leq 0.15 \cdots \text{Formula (2)}$$

<3> The method of manufacturing a biaxially stretched thermoplastic resin film according to <1> or <2>, wherein the length B of the gripping member is 100 to 140 mm.

<4> The method of manufacturing a biaxially stretched thermoplastic resin film according to any one of <1> to <3>, wherein in at least one of the thermal fixing and the thermal relaxing, the maximum arrival temperature of the film surface (hereinafter, referred to as a maximum arrival film surface temperature) is controlled to be within a range of 160 to 210°C.

<5> The method of manufacturing a biaxially stretched thermoplastic resin film according to any one of <1> to <4>, wherein the thermoplastic resin contains polyethylene terephthalate, and the thermoplastic resin film is a polyester film containing polyethylene terephthalate.

<6> The method of manufacturing a biaxially stretched thermoplastic resin film according to any one of <1> to <5>, wherein the thickness of the thermoplastic resin film after the transverse stretching process is 180 to 400 $\mu$m.

In addition the patent specification discloses:

<7> A biaxially stretched thermoplastic film that is manufactured by the method of manufacturing a biaxially stretched thermoplastic resin according to any one of <1> to <6>, wherein a thermal contraction ratio when being subjected to the heat treating in treatment conditions of 150°C and 30 minutes is 2.0% or less.

<8> The biaxially stretched thermoplastic resin film according to <7>, wherein the thermoplastic resin film is a polyester film including polyethylene terephthalate, and an intrinsic viscosity (IV) of the polyester film is 0.70 to 0.80.

<9> A back sheet for a solar cell including the biaxially stretched thermoplastic resin film according to <7> or <8>.

<10> A solar cell module including: a transparent substrate to which solar light is incident; a solar cell element that is disposed on one side of the substrate; and the back sheet for a solar cell according to <9> that is disposed at a side of the substrate, which is opposite to the side at which the solar cell element is disposed.

A biaxially stretched thermoplastic resin film, which is excellent in dimensional stability and hydrolysis resistance, and a manufacturing method thereof according to the invention may be provided.

In addition, a back sheet for a solar cell, which is excellent in a durability performance over a long time, may be provided.

In addition, a solar cell module, which is capable of stably obtaining a power generation performance over a long time, may be provided.

**BRIEF DESCRIPTION OF THE DRAWINGS**

Fig. 1 is a top view illustrating an example of a transverse stretching machine, which is used in a transverse stretching process after longitudinal stretching, from the top face.

Fig. 2A is a schematic diagram illustrating arrangement of gripping members and a grip distance A before narrowing a distance between gripping members that are adjacent to each other and Fig. 2B is a schematic diagram illustrating arrangement of the gripping members and a grip distance C after narrowing a distance between the gripping members that are adjacent to each other.

## DESCRIPTION OF THE PREFERRED EMBODIMENTS

Hereinafter, a biaxially stretched thermoplastic resin film and a manufacturing method thereof according to the invention will be described in detail, and a back sheet for a solar cell and a solar cell module, which use the biaxially stretched thermoplastic resin film, will be described in detail.

<Method of Manufacturing Biaxially Stretched Thermoplastic Resin Film>

A method of manufacturing a biaxially stretched thermoplastic resin film according to the invention includes at least a sheet forming process of performing melt extrusion of a thermoplastic resin into a sheet form and cooling the resultant sheet on a casting drum to form a thermoplastic resin sheet, a longitudinal stretching process of longitudinally stretching the thermoplastic resin sheet, which is formed, in a longitudinal direction (MD; Machine Direction), and a transverse stretching process of gripping the thermoplastic resin sheet after the longitudinal stretching by a gripping member (for example, a stretching clip) and transversely stretching the thermoplastic resin sheet in a transverse direction (TD: Transverse Direction) orthogonal to the longitudinal direction. The transverse stretching process includes a preheating process of preheating the thermoplastic resin sheet after the longitudinal stretching to a stretchable temperature, a stretching process of applying a tension to the thermoplastic resin sheet, which is preheated, in the transverse direction orthogonal to the longitudinal direction to transversely stretch the thermoplastic resin sheet, a thermal fixation process of heating the thermoplastic resin film that is obtained by the longitudinal stretching and the transverse stretching to crystallize and thermally fix the thermoplastic resin film, a thermal relaxation process of relaxing the tension applied to the thermoplastic resin film that is thermally fixed to remove remaining strain, and a cooling process of cooling the thermoplastic resin film after the thermal relaxation.

Among these processes, at least one of the thermal fixation process and the thermal relaxation process performs contraction treatment of the thermoplastic resin film in the longitudinal direction of the film in such a manner that a contraction ratio expressed by the following Formula (1) is within a range of 3 to 8% while narrowing a grip distance between gripping members adjacent to each other.

$$[\{(A+B)-(C+B)\}/(A+B)]\times100 \cdots \text{Formula (1)}$$

The total contraction treatment time in the thermal fixation process and the thermal relaxation process is set to 10 to 60 seconds, and an average rising rate of a film surface temperature from a termination point of time of the transverse stretching in the stretching process until a film surface temperature reaches the maximum arrival temperature in an interval in which the contraction treatment is performed so as to satisfy the contraction ratio is set to 0.6 to 4.5 °C/second.

In Formula (1), A represents a grip distance (mm) before narrowing the distance between the gripping members adjacent to each other, B represents the length (mm) of each of the gripping members in the longitudinal direction of the film, and C represents a grip distance (mm) after narrowing the distance between the gripping members adjacent to each other.

Various reviews have been made with respect to dimensional stability of a thermoplastic resin film (hereinafter, simply referred to as a "resin film"), and stability of some degree is expected, but separate countermeasures have been used to improve, for example, hydrolysis resistance of polyester or the like in which carboxy groups or hydroxyl groups are present on a surface thereof in a large amount. However, in a technology known in the related art, one of the dimensional stability and the hydrolysis resistance may be increased, but both of these are not considered together. According to the invention, in consideration of this circumstance, in the thermal fixation process and/or the thermal relaxation process after the transverse stretching in the transverse stretching process of performing the transverse stretching with respect to the thermoplastic resin that is longitudinally stretched, contraction treatment of the thermoplastic resin film is performed to obtain a predetermined contraction ratio while narrowing gripping members that are adjacent to each other among gripping members that are disposed in a film conveying direction, and the sum of contraction treatment times during this contraction treatment and an average rising rate of a film surface temperature at this time are set to satisfy a predetermined range, whereby the dimensional stability of the thermoplastic resin film is improved while high hydrolysis resistance is provided.

The hydrolysis resistance of the resin film becomes favorable by applying tension to the film so as to cause polymer molecules to be stretched in a longitudinal direction of the molecules. On the other hand, in regard to the dimensional stability of the film, a state in which a distance between molecular chains of the polymer molecules is shortened is preferable. This is considered to be because when the space between molecular chains of the polymer molecules is empty, the distance between the molecular chains is apt to be shortened due to interaction between the molecules, and thus the dimensional stability of the film is deteriorated (that is, the thermal contraction ratio increased).

Therefore, to make the hydrolysis resistance and the dimensional stability of the thermoplastic resin film be compatible with each other, for example, making the distance between the molecular chains of the polymer molecules not be shortened by applying tension to the film is considered.

Here, in regard to the stretching, generally, stretching (longitudinal stretching) in a film conveying direction and stretching (transverse stretching) in a direction orthogonal to the film conveying direction are performed by an apparatus provided with rolls, gripping members, and the like. However, in regard to the transverse stretching, stretching treatment is performed by sequentially conveying the film to a preheating section that heats the film in advance during the stretching, a stretching section that gives tension to the film so as to stretch the film, a thermal fixation section that heats the film while the tension is applied to the film, a thermal relaxation section that relaxes the tension of the film, and a cooling section that cools the film.

In the invention, to make the hydrolysis resistance and the dimensional stability of the thermoplastic resin film be compatible with each other, among the respective processes making up the transverse stretching process, in the thermal fixation process and/or the thermal relaxation process after the transverse stretching, contraction treatment of the thermoplastic resin film in the longitudinal direction of the film is performed in such a manner that a contraction ratio expressed by the following Formula (1) is within a range of 3 to 8% while narrowing a grip distance between gripping members adjacent to each other. That is, the relaxation treatment is performed in the longitudinal direction (MD; Machine Direction) of the resin film during the transverse stretching process. Due to this contraction process, the dimensional stability of the resin film may be increased.

$$<<\text{Formula (1)}>>$$

$$[\{(A+B)-(C+B)\}/(A+B)]\times 100$$

    A: Grip distance (mm) before narrowing the distance between the gripping members adjacent to each other
    B: Length of each of the gripping members in the longitudinal direction of the film
    C: Grip distance (mm) after narrowing the distance between the gripping members adjacent to each other

During the transverse stretching, since tension is applied to the film due to the stretching in the transverse direction of the film in the stretching section, and thus the polymer molecules are stretched, as a result, the hydrolysis resistance of the film is improved, and on the other hand, since a distance between the molecular chains of the polymer molecules is lengthened, the dimensional stability tends to be deteriorated. According to the invention, after the transverse stretching, commonly, the thermal relaxation in the film transverse direction is performed, and thus the tension in the film transverse direction is relaxed in the thermal relaxation section. Therefore, in addition to the transverse direction of the film, the relaxation treatment is performed in the longitudinal direction (MD) of the film during the thermal fixation process and/or the thermal relaxation process in the transverse stretching process, and thus the tension in the MD is relaxed. As a result, the dimensional stability of the film is further improved compared to the related art. That is, the film is contracted in the transverse direction and in the MD of the film, and thus a distance between molecular chains of polymer molecules may be narrowed.

At this time, when the tension is relaxed due to the thermal relaxation, the hydrolysis resistance tends to be deteriorated. However, when the film contraction ratio at this time is set to 3 to 8%, and a treatment time during the contraction treatment and an average rising rate of the film surface temperature from a termination point of time of the transverse stretching in the stretching process until the film surface temperature reaches the maximum arrival temperature during the contraction treatment are adjusted to a predetermined range, the hydrolysis resistance may be made to be excellent while the dimensional stability of the resin film is maintained to be high.

The method of manufacturing the biaxially stretched thermoplastic resin film of the invention includes the sheet forming process, the longitudinal stretching process, and the transverse stretching process in this order. However, in the following description, first, the transverse stretching process will be described in detail, and then the respective processes of the sheet forming process and the longitudinal stretching process will be described in detail.

[Transverse Stretching Process]

In the transverse stretching process of the invention, the thermoplastic resin film after the longitudinal stretching in the longitudinal stretching process to be described later is transversely stretched in a transverse direction orthogonal to the longitudinal direction. In this process, this transverse stretching is performed by providing a preheating process of preheating the thermoplastic resin sheet after the longitudinal stretching to a stretchable temperature, a stretching process of applying a tension to the thermoplastic resin sheet, which is preheated, in the transverse direction orthogonal to the longitudinal direction to transversely stretch the thermoplastic resin sheet, a thermal fixation process of heating the thermoplastic resin film that is obtained by the longitudinal stretching and the transverse stretching to crystallize and thermally fix the thermoplastic resin film, a thermal relaxation process of relaxing the tension applied to the thermoplastic resin film that is thermally fixed to remove remaining strain, and a cooling process of cooling the thermoplastic resin film after the thermal relaxation.

In the transverse stretching process of the invention, specific means thereof is not limited as long as the thermoplastic resin film is transversely stretched by the above-described configuration. The present process may be appropriately performed by a transverse stretching apparatus provided with respective sections capable of performing treatment of the respective processes making up the above-described configuration (specifically, a preheating zone that performs preheating, a stretching zone that perform transverse stretching, a thermal fixation zone that performs thermal fixation, a thermal relaxation zone that relaxes tension, and a cooling zone that performs cooling).

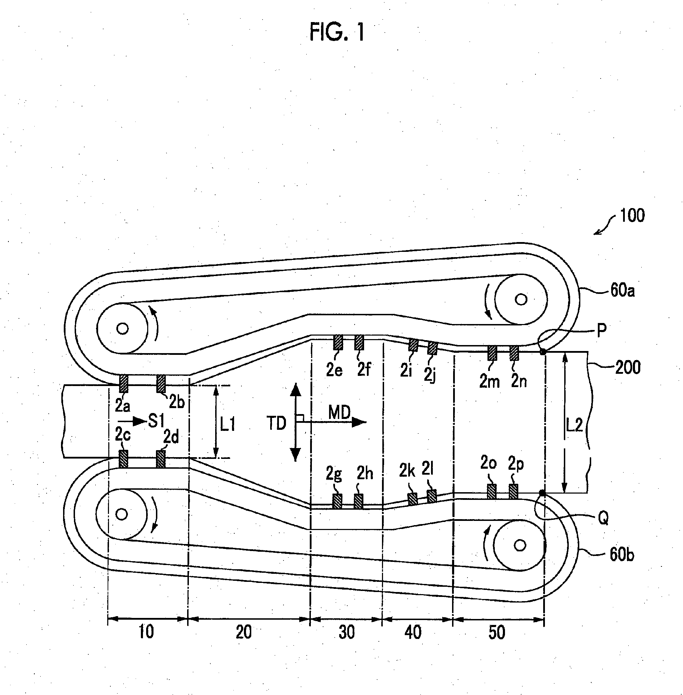

Here, an example of the transverse stretching apparatus that transversely stretches polyester as the thermoplastic resin will be described with reference to Fig. 1. Fig. 1 shows a top view illustrating an example of the transverse stretching apparatus from the top face.

As shown in Fig. 1, a transverse stretching apparatus 100 is a transverse stretching tenter and includes a pair of circular rails 60a and 60b, and stretching clips 2a to 2p as gripping members, which are mounted in the respective circular rails and which are capable of moving along the rails. The circular rails 60a and 60b are symmetrically disposed with a polyester film 200 interposed therebetween, and the polyester film 200 is made to move along the rails while being gripped by the stretching clips 2a to 2p, whereby the polyester film 200 may be stretched in a transverse direction of the film 200.

The transverse stretching apparatus 100 includes a preheating section (preheating zone) 10 that preheats the polyester film 200, a stretching section (stretching zone) 20 that stretches the polyester film 200 in an arrow TD direction that is orthogonal to an arrow MD direction to apply tension to the polyester film 200, a thermal fixation section (thermal fixation zone) 30 that heats the polyester film 200 while the tension is applied to the polyester film 200, a thermal relaxation section (thermal relaxation zone) 40 that heats the polyester film 200 to relax tension of the polyester film 200 that is thermally fixed, and a cooling section (cooling zone) 50 that cools the polyester film 200 that passed through the thermal relaxation section 40.

In the circular rail 60a, the stretching clips 2a, 2b, 2e, 2f, 2i, 2j, 2m, and 2n that are movable along the circular rail 60a are mounted, and in the circular rail 60b, the stretching clips 2c, 2d, 2g, 2h, 2k, 21, 2o, and 2p that are movable along the circular rail 60b are mounted. The stretching clips 2a, 2b, 2e, 2f, 2i, 2j, 2m, and 2n grip one end portion of the polyester film 200 in the TD direction and the stretching clips 2c, 2d, 2g, 2h, 2k, 21, 2o, and 2p grip the other end portion of the polyester film 200 in the TD direction. The stretching clips 2a to 2p are generally called chucks or the like. The stretching clips 2a, 2b, 2e, 2f, 2i, 2j, 2m, and 2n move along the circular rail 60a by a counterclockwise rotation, and the stretching clips 2c, 2d, 2g, 2h, 2k, 21, 2o, and 2p move along the circular rail 60b by a clockwise rotation.

The stretching clips 2a to 2d grip the end portion of the polyester film 200 in the preheating section 10, move along the circular rails 60a or 60b in a gripping state, sequentially pass through the stretching section 20, the thermal fixation section 30 at which the stretching clips 2e to 2h are located, and the thermal relaxation section 40 at which the stretching clips 2i to 21 are located, and proceeds to the cooling section 50 at which the stretching clips 2m to 2p are located. Then, the stretching clips 2a and 2b and the stretching clips 2c and 2d detach end portions (point P and point Q) of the cooling section 50 downstream of the MD direction and the end portion of the polyester film 200 from each other in a conveyance sequence, and further move along the circular rail 60a or 60b, and then return to the preheating section 10. At this time, the polyester film 200 sequentially moves in the arrow MD direction, and is subjected to a preheating process in the preheating section 10, a stretching process in the stretching section 20, a thermal fixation process in the thermal fixation section 30, a thermal relaxation process in the thermal relaxation section 40, and a cooling process in the cooling section 50, whereby the transverse stretching is performed. A moving velocity of the stretching clips 2a to 2p in the respective sections such as the preheating section 10 becomes a conveyance velocity of the polyester film 200.

The moving velocity of the stretching clips 2a to 2p may be changed independently by a linear motor or the like. When the moving velocity of the stretching clips are changed, as described later, not only the transverse stretching but also the relaxation in the MD direction are performed.

In addition, as the stretching clips that grip the end portion in the TD direction of the polyester film 200, only 2a to 2p are shown in Fig. 1. However, they are not limited these, and in addition to the stretching clips 2a to 2p, stretching clips (not shown) are mounted to support the polyester film 200.

In the following description, stretching clips 2a to 2p are collectively referred to as a "stretching clip 2".

(Preheating Process)

In the preheating process, a thermoplastic resin film that is longitudinally stretched in the longitudinal stretching process to be described later is preheated to a stretchable temperature. For example, as shown in Fig. 1, the polyester film 200 is preheated in the preheating section 10. In the preheating section 10, the thermoplastic resin film is heated in advance before being transversely stretched so as to easily perform the transverse stretching of the thermoplastic resin film.

When a glass transition temperature of the thermoplastic resin film is set to Tg, a film surface temperature (hereinafter, also referred to as a "preheating temperature") at a preheating section termination point is preferably Tg-10°C to Tg+60°C, and more preferably Tg to Tg+50°C. In addition, the preheating section termination point is a point of time at which the preheating of the thermoplastic resin film is terminated, that is, a position at which the thermoplastic resin film is distant from the region of the preheating section 10.

(Stretching Process)

In the stretching process, tension is applied to the thermoplastic resin film that is preheated in the preheating process in a transverse direction (TD direction) that is orthogonal to the longitudinal direction (MD direction) so as to transversely stretch the film. For example, as shown in Fig. 1, in the stretching section 20, the polyester film 200, which is preheated, is transversely stretched at least in the TD direction orthogonal to the longitudinal direction of the polyester film 200 to apply tension to the thermoplastic resin film.

The stretching (transverse stretching) in the direction (TD) orthogonal to the longitudinal direction (MD) of the polyester film 200 is intended to stretch the polyester film 200 in a direction that intersects perpendicularly (at 90°) the longitudinal direction (MD) of the polyester film. However, it cannot be said that it is 90° due to a mechanical error range, but it may be a direction that is substantially the same as 90°. The mechanical error range is a direction within an angle range (specifically, a range of 90°±5°) that may be regarded to be perpendicular to the longitudinal direction (MD) of the film.

In the stretching section 20, the tension (stretching tension) that is applied to the thermoplastic resin film for the transverse stretching is preferably 0.1 to 6.0 t/m.

In addition, an area stretching magnification (product of respective stretching ratios) of the thermoplastic resin film is preferably 6 to 18 times an area of the thermoplastic resin film before the stretching, more preferably 8 to 17.5 times, and still more preferably 10 to 17 times.

In addition, when a glass transition temperature of the thermoplastic resin film is set to Tg, the film surface temperature at the time of the transverse stretching of the thermoplastic resin film (hereinafter, referred to as a "transverse stretching temperature) is preferably Tg-10°C to Tg+100°C, more preferably Tg to Tg+90°C, and still more preferably Tg+10°C to Tg+80°C.

As described above, the moving velocity of the stretching clips 2a to 2p may be changed independently. Therefore, for example, when the moving velocity of the stretching clip 2 in the preheating section 10 is made to be faster than that of the stretching clip 2 in the stretching section 20 and the thermal fixation section 30 and the like that are located downstream of the stretching section 20 in the MD direction, the longitudinal stretching for stretching the thermoplastic resin film in the conveyance direction (MD) may be performed in addition. The longitudinal stretching of the thermoplastic resin film in the transverse stretching process may be performed by only the stretching section 20.

(Thermal Fixation Process)

In the thermal fixation process, the thermoplastic resin film, which is subjected to the longitudinal stretching and the transverse stretching in advance, is heated so as to crystallize and thermally fix the film. For example, as shown in Fig. 1, the polyester film 200 to which tension is applied is heated in the thermal fixation section 30.

In addition, the thermal fixation represents a process of heating the thermoplastic resin film to a specific temperature while tension applied to the thermoplastic resin film in the stretching section 20 is maintained so as to crystallize the thermoplastic resin film.

In the invention, when the heating is performed in such a manner that the maximum arrival film surface temperature (in this specification, also referred to as "thermal fixation temperature") of the surface of the thermoplastic resin film is within a range of 160 to 210°C, the thermal fixation may be appropriately performed. When the thermoplastic resin film to which tension is applied is heated at the thermal fixation temperature range of 160 to 210°C, a polymer molecule crystal is aligned and thus the hydrolysis resistance may be applied to the thermoplastic resin film. That is, when the thermal fixation temperature is set to 160°C or higher, a contraction ratio becomes large and the dimensional stability becomes preferable. Furthermore, in regard to the hydrolysis resistance, the thermoplastic resin such as polyester tends to be crystallized, and the polymer molecule such as a polyester molecule is fixed in a state of being stretched, and thus the hydrolysis resistance may be enhanced. In addition, when the thermal fixation temperature is 210°C or less, the dimensional stability tends to be improved, and thus contraction of the polymer molecule, which is derived from entanglement between polymer molecules, is suppressed. Therefore, the hydrolysis resistance may be maintained to be high.

From this reason, the thermal fixation temperature is preferably 170 to 200°C, and more preferably 175 to 195°C.

The maximum arrival film surface temperature (thermal fixation temperature) is a value that is measured by bringing a thermocouple into contact with the surface of the thermoplastic resin film.

In the invention, the thermal fixation process and/or the thermal relaxation process to be described later, a contraction process in a longitudinal direction (MD) (hereinafter, also referred to as "MD contraction") of the thermoplastic resin film is performed. When this MD contraction is performed, the dimensional stability and the hydrolysis resistance of the film may be improved together.

When the contraction ratio satisfies a predetermined range and thus the dimensional stability and the hydrolysis resistance are satisfied, the MD contraction may be performed by either the thermal fixation process or the thermal relaxation process to be described later. For example, in a case where the MD contraction is performed in the thermal fixation process, it is not necessary to perform the MD contraction in the thermal relaxation process to be described later. In addition, the MD contraction may be performed only in the thermal relaxation process while not performing the MD contraction in the thermal fixation process. The MD contraction may be performed both in the thermal fixation process and the thermal relaxation process.

The contraction process (MD contraction) of the invention is performed, for example, by contracting the thermoplastic resin film in a state in which the film is gripped by gripping members disposed in a transverse stretching apparatus or the like in such a manner that a contraction ratio, which is expressed by the following Formula (1), becomes 3 to 8% while narrowing a grip distance in a longitudinal direction of the film. Specifically, the contraction treatment may be performed, for example, as shown in Fig. 1, by narrowing a grip distance by changing individual moving velocities of the stretching clips (for example, between stretching clips 2e and 2f, between 2g and 2h, between 2i and 2j, between 2k and 2l, between 2m and 2n, and between 2o and 2p) that are located behind and in front of each other to narrow an inter-clip distance.

$$[\{(A+B)-(C+B)\}/(A+B)]\times 100 \cdots \text{ Formula (1)}$$

Specifically, the relaxation of the thermoplastic resin film in the MD direction may be performed by narrowing the distance between the stretching clips 2e and 2f, and the distance between the stretching clips 2g and 2h at the downstream-side thermal fixation section and/or the thermal relaxation section rather than the upstream side in the MD direction. In a case where the relaxation in the MD direction is performed by the thermal fixation section 30 and/or the thermal relaxation section 40, the distance between the stretching clips 2e and 2f and the distance between the stretching clips 2g and 2h may be made to be narrower than that at the upstream side thereof, for example, at the preheating section 10 and the like by making the moving velocity of the stretching clips slow and by making the conveyance velocity of the thermoplastic resin film slow when the stretching clips 2e to 2h reach the thermal fixation section 30 and the thermal relaxation section 40.

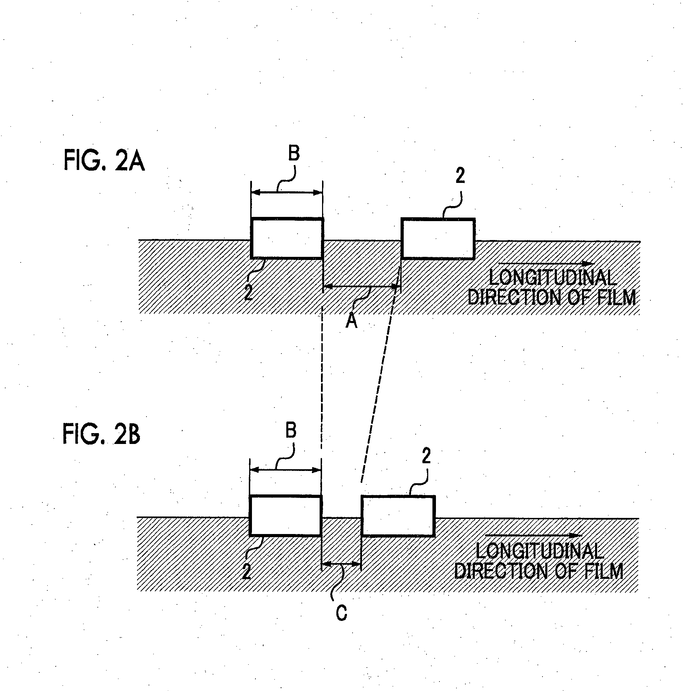

In Formula (1), as shown in Fig. 2A, A represents a grip distance A (mm) before narrowing the distance between two gripping members 2 adjacent to each other, and as shown in Fig. 2B, C represents a grip distance C (mm) after narrowing the distance between the two gripping members 2 adjacent to each other. In addition, B represents the length (mm) of each of the gripping members 2 in the longitudinal direction of the film.

The contraction ratio expressed by Formula (1) may be 3 to 8% as the sum of contraction ratios both in the thermal fixation process and the thermal relaxation process to be described later.

In the process of the invention, when the contraction ratio expressed by Formula (1) exceeds 8%, a state in which wrinkles or the thickness in the transverse direction (TD) of the film is not uniform tends to be worse, and the dimensional stability is deteriorated. In addition, when the contraction ratio is less than 3%, particularly, the dimensional stability in the longitudinal direction (MD) of the film is not improved and thus the dimensional stability is deteriorated.

From the above-described reason, it is preferable that the contraction ratio be 4 to 6%.

In addition, an aspect in which the length B of the gripping member and the grip distance A before narrowing the distance between gripping members that are adjacent to each other satisfy a relational formula shown in the following Formula (2) is preferable. This relational formula represents a ratio of a gap between gripping members with respect to a distance between one end of one gripping member and the same one end of another gripping member.

$$0.06 \leq A/(A+B) \leq 0.15 \cdots \text{Formula (2)}$$

There was a tendency to make the gap large from the viewpoints of obtaining large contraction ratio in the related art, but a difference in stretching stress between a gripped portion using gripping members and a not-gripped portion occurred during transverse stretching, and thus particularly, an end portion of a film in a transverse direction thereof had a tendency to be stretched in a non-uniform manner. Therefore, in the invention, when the length B of the gripping member and the grip distance A satisfy Formula (2), stretching uniformity may be maintained. Specifically, when the ratio of the gap is 0.06 or more, a difference in contraction, which is apt to occur between the center of the film and an end portion in a transverse direction of the film, is suppressed and thus basic properties such as a thermal contraction ratio become uniform. As a result, the dimensional stability becomes excellent. In addition, when the ratio of the gap is 0.15 or less, a difference in the stretching stress between the gripped portion and the not-gripped portion during the transverse stretching is reduced and thus the dimensional stability becomes preferable.

From the above-described reason, it is more preferable that the ratio [A/(A+B)] of the gap be 0.07 to 0.13.

In addition, it is preferable that the length B of the gripping member be within a range of 100 to 140 mm. When the relational formula shown in Formula (2) is satisfied and the length of the gripping member is set to a range of 100 mm or more, the difference in the stretching stress between the gripped portion and the not-gripped portion during the transverse stretching is suppressed to be small and thus the stretching uniformity is maintained. When the length of the gripping member is set to a range of 140 mm or less, a difference in contraction between the center and the end portion of the film is suppressed and thus the uniformity of the basic properties are maintained.

From the above-described reason, it is preferable that the length B of the gripping member be 110 to 125 mm.

The contraction treatment (MD contraction) is performed in such a manner that the total contraction treatment time in the thermal fixation process and the thermal relaxation process to be described later becomes 10 to 60 seconds. When the treatment time exceeds 60 seconds, an increase in haze of the thermoplastic resin is caused, and the hydrolysis resistance is deteriorated, whereby quality deterioration is caused. Particularly, the increase in haze is significant in a crystalline resin such as polyester (for example, polyethylene terephthalate and the like). In addition, when the treatment time is less than 10 seconds, the contraction ratio is not sufficient and a surface state defect such as wrinkles occurs during contraction in addition to the deterioration of the dimensional stability. In addition, the hydrolysis resistance is deteriorated and thus it is difficult to maintain quality durability over a long period of time.

From the above-described reason, it is preferable that the contraction treatment time be 10 to 40 seconds, and more preferably 15 to 30 seconds.

In addition, an average rising rate of a film surface temperature from a termination point of time of the transverse stretching in the stretching process until a film surface reaches the maximum arrival temperature "in an interval in which the contraction treatment is performed in order for the contraction ratio expressed by Formula (1) to satisfy range" is set to 0.6 to 4.5 °C/second.

The termination point of time of the transverse stretching is a point of time at which the transverse stretching is terminated after the film reaches a stretching zone exit, and represents, for example, a position at which it enters the thermal fixation section 30 from the stretching section 20 in the apparatus shown in Fig. 1.

Here, the "average rising rate" of the film surface temperature is a value that is obtained by dividing a difference in a temperature (T2-T1; °C) between the film surface temperature T1 [°C] at the stretching zone exit and the film surface maximum arrival temperature T2 [°C] in an interval in which contraction in a longitudinal direction of a film is performed by a necessary time [second].

When the average rising rate exceeds 4.5 °C/second, in addition to a significant decrease in the hydrolysis resistance, the film is rapidly heated and thus uneven contraction occurs. When the unevenness is large, a surface state defect such as wrinkles occurs. On the other hand, when the average rising rate is slower than 0.6 °C/second, it is preferable from the viewpoints of uniform contraction, but due to a condition selection in which a temperature condition during the thermal fixation or the thermal relaxation is set to a low temperature, the lengthening of a zone length, a decrease in a manufacturing speed, and the like, the thermal contraction may be excessively large, or high cost may be caused.

It is preferable that the average rising rate be 1.0 to 4.2 °C/second, and more preferably 1.3 to 4.0 °C/second.

The adjustment of the average rising rate of the film surface temperature is not particularly limited, and for example, the adjustment may be performed by providing a device such as a heating unit including a heater and a blowing unit including a blowing fan in the thermal fixation zone or the thermal relaxation zone so as to function as an adjustment unit and by changing a temperature or airflow velocity of a heating airflow that is supplied to the film.

(Thermal Relaxation Process)

The thermal relaxation process relaxes (thermally relaxes) tension of the thermoplastic resin film that is thermally fixed by the thermal fixation process to remove remaining strain of the film. Due to this process, the dimensional stability of the film is improved. In addition, in a case where the contraction treatment (MD contraction) in the longitudinal direction (MD) of the thermoplastic resin film is not performed in the thermal fixation process, the MD contraction is performed in the thermal relaxation process. When this MD contraction is performed, as described above, the dimensional stability and hydrolysis resistance of the film are improved together.

As a preferable aspect of the thermal relaxation, for example, as shown in Fig. 1, the thermoplastic resin film is heated in the thermal relaxation section 40 in such a manner that the maximum arrival film surface temperature of the thermoplastic resin film becomes lower than the maximum arrival film surface temperature ($T_{thermal\ fixation}$) of the thermoplastic resin film in the thermal fixation section 30 by 5°C or higher to apply the thermal relaxation to the thermoplastic resin film. Hereinafter, the maximum arrival film surface temperature of the thermoplastic resin film during the thermal relaxation is also referred to as "thermal relaxation temperature ($T_{thermal\ relaxation}$).

Similarly to a case in which the MD contraction is performed by the thermal fixation process, the MD contraction in the thermal relaxation process may be performed simultaneously with the performing of the MD contraction by the thermal fixation process. In a case where the MD contraction is performed by the thermal fixation process, the MD contraction in the thermal relaxation process may not be performed. Conversely, the MD contraction may be performed only in the thermal relaxation process.

Even in a case where the contraction treatment (MD contraction) is performed in this process, similarly to the case of the thermal fixation process, for example, in a state in which the film is gripped by the gripping members that are provided in the transverse stretching apparatus or the like, the thermoplastic resin film is contracted in such a manner that the contraction ratio expressed by Formula (1) becomes 3 to 8% while narrowing the grip distance in the longitudinal direction of the film. The contraction ratio may be set to be 3 to 8% only in this thermal relaxation process. It is preferable that the contraction ratio be 4 to 6% similarly to the thermal fixation process.

In the thermal relaxation process, details of the contraction ratio during the MD contraction, a preferable range thereof, and the like, the ratio of A/(A+B), a preferable range thereof, and the like, a range of the length B of the gripping member, a preferable range thereof, and the like, the contraction treatment time, a preferable range thereof, and the like are the same as the case of the thermal fixation process.

Specifically, in the thermal relaxation process, it is preferable that the length B of the gripping member and the grip distance A satisfy a relationship expressed by Formula (2), and it is preferable that a ratio of A/(A+B) be 0.07 to 0.13.

In addition, it is preferable that the length B of the gripping member be 100 to 140 mm, and more preferably 110 to 125 mm.

The contraction treatment (MD contraction) is performed in such a manner that the total contraction treatment time of the above-described thermal fixation process and thermal relaxation process becomes 10 to 60 seconds, more preferably 10 to 40 seconds, and more preferably 15 to 30 seconds.

The average rising rate is set to 0.6 to 4.5 °C/second. A preferable average temperature rising rate is 1.0 to 4.2 °C/second, and more preferably 1.3 to 4.0 °C/second.

In the thermal relaxation section 40, relaxation of the thermoplastic resin film at least in TD is performed. At this time, the relaxation of the thermoplastic resin film in the MD may be performed. Due to this treatment, the thermoplastic resin film to which tension is applied may be contracted in the TD and MD The relaxation in the TD may be performed by weakening the stretching tension, which is applied to the thermoplastic resin film in the stretching section 20, by 2 to 90%. In the invention, it is preferable to weaken the stretching tension to 40%.

(Cooling Process)

In the cooling process, the thermoplastic resin film, which is thermally relaxed in the thermal relaxation process, is cooled.

For example, in an aspect shown in Fig. 1, the thermoplastic resin film that passes through the thermal relaxation section 40 is cooled in the cooling section 50. When the thermoplastic resin film, which is heated in the thermal fixation section 30 or the thermal relaxation section 40, is cooled, the shape of the thermoplastic resin film is fixed.

It is preferable that a film surface temperature (hereinafter, referred to as a "cooling temperature") of the polyester 200 at a cooling section exit in the cooling section 50 be lower than the glass transition temperature Tg of the thermoplastic resin film + 50°C. Specifically, 25 to 110°C is preferable, more preferably 25 to 95°C, and more preferably 25 to 80°C. When the cooling temperature is within the above-described range, the film is prevented from being contracted in a non-uniform manner after releasing the clip gripping.

Here, the cooling section exit represents an end portion of the cooling section 50 when the polyester 200 is distant from the cooling section 50, and represents a position when the gripping members 2 (in Fig. 1, gripping members 2j and 21) that grip the thermoplastic resin film are detached from the thermoplastic resin film.

In addition, in regard to the preheating, the stretching, the thermal fixation, the thermal relaxation, and the cooling in the transverse stretching process, as temperature control means for heating or cooling the thermoplastic resin film, warm airflow or cold airflow is supplied to the thermoplastic resin film, or the thermoplastic resin film is brought into contact with a surface of a temperature-controllable metal plate or made to pass through the vicinity of the metal plate.

(Recovery of Film)

The thermoplastic resin film that is cooled in the cooling process is cut at a portion that is gripped by the gripping members in both ends in the TD direction, and is wound into a roll shape.

In the transverse stretching process, relaxation of the stretched thermoplastic resin film is preferably performed by the following method to relatively increase the hydrolysis resistance and the dimensional stability of the thermoplastic resin film that is manufactured.

In the invention, relaxation in the MD direction may be further performed in the cooling section 50 after performing the transverse stretching as described above.

Specifically, both end portions of the thermoplastic resin film in the transverse direction (TD) are gripped in the preheating section 20 by using at least two gripping members for each end portion. For example, one end portion of the thermoplastic resin film in the transverse direction (TD) is gripped by the gripping members 2a and 2b, and the other end portion is gripped by the gripping members 2c and 2d. Subsequently, the gripping members 2a to 2d are made to move so as to convey the thermoplastic resin film from the preheating section 20 to the cooling section 50.

In the corresponding conveyance, a distance between the gripping member 2a (2c) that grips one end portion of the thermoplastic resin film in the transverse direction (TD direction) and another gripping member 2b (2d) that is adjacent to the gripping member 2a (2c) in the cooling section 50 is made to be narrower than a distance between the gripping member 2a (2c) that grips one end portion of the thermoplastic resin film in the transverse direction and another gripping member 2b (2d) that is adjacent to the gripping member 2a (2c) in the preheating section 10 to make the conveyance velocity of the thermoplastic resin film slow. According to the corresponding method, the relaxation in the MD direction may be performed in the cooling section 50.

As described above, the relaxation of the thermoplastic resin film in the longitudinal direction (MD) is performed in at least a part of the thermal fixation section 30 and the thermal relaxation section 40 or in both of these. In addition, the relaxation in the MD may be further performed in the cooling section 50 as necessary.

Next, the sheet forming process and the longitudinal stretching process, which are provided before the transverse stretching process, will be described in detail.

[Sheet Forming Process]

In the sheet forming process, a raw material of the thermoplastic resin (preferably, polyester raw material resin) is melted and extruded into a sheet form, and is cooled on a casting drum to form a thermoplastic resin sheet (preferably, a polyester sheet). In the invention, among thermoplastic resin sheets, a polyester sheet having an intrinsic viscosity (IV) of 0.70 to 0.80 dL/g is appropriately formed.

A method of melting and extruding the polyester raw material resin and the polyester raw material resin are not particularly limited as long as the method and the polyester are capable of obtaining an ultimate polyester film having the intrinsic viscosity of 0.70 to 0.80 by melting and extruding the polyester raw material resin and by performing cooling, but the intrinsic viscosity may be set to a desirable intrinsic viscosity by a catalyst that is used for synthesis of the polyester raw material resin, a polymerization method, and the like.

Examples of the thermoplastic resin include polyester, polyethylene, polypropylene, polyvinyl chloride, polystyrene, polyacetal, polyimide, polyamide, and the like. Among these, a polyester resin including polyester is preferable from the viewpoints of durability over a long period of time and appropriate application, for example, for a solar cell use.

Polyester is a linear saturated polyester that is synthesized from an aromatic dibasic acid or an ester-forming derivative thereof and a diol or an ester-forming derivative thereof. Specific examples of this polyester include polyethylene terephthalate, polyethylene isophthalate, polybutylene terephthalate, poly(1,4-cyclohexylenedimethylene terephthalate), and polyethylene-2,6-naphthalate. Among these, polyethylene terephthalate or polyethylene-2,6-naphthalate is particularly preferable from the viewpoints of the balance between mechanical properties and cost.

The polyester may be a homopolymer, or may be a copolymer. Furthermore, the polyester may be blended with a small amount of a different type of resin, for example, a polyimide.

As the thermoplastic resin in the invention, polyester, particularly, polyethylene terephthalate is preferable.

Hereinafter, among the thermoplastic resins, polyester raw material resin will be described.

(Polyester Raw Material Resin)

The polyester raw material resin is not particularly limited as long as the polyester raw material contains polyester resin that becomes a raw material of the polyester film, and may contain a slurry of inorganic particles or organic particles other than polyester. In addition, the polyester raw material resin may contain an elemental titanium derived from a catalyst.

A kind of polyester that is contained in the polyester raw material resin is not particularly limited.

Polyester may be synthesized using a dicarboxylic acid component and a diol component, and commercially available polyester may be used.

In the case of synthesizing polyester, for example, polyester may be obtained by subjecting the dicarboxylic acid component (A) and the diol component (B) to an esterification reaction and/or a transesterification reaction by a known method.

Examples of the polyvalent carboxylic component (A) include dicarboxylic acids such as aliphatic dicarboxylic acids such as malonic acid, succinic acid, glutaric acid, adipic acid, suberic acid, sebacic acid, dodecanedionic acid, dimer acid, eicosanedionic acid, pimellic acid, azelaic acid, methylmalonic acid, and ethylmalonic acid; alicyclic dicarboxylic acids such as adamantanedicarboxylic acid, norbornenedicarboxylic acid, isosorbide, cyclohexanedicarboxylic acid, and decalin dicarboxylic acid; and aromatic dicarboxylic acids such as terephthalic acid, isophthalic acid, phthalic acid, 1,4-naphthalenedicarboxylic acid, 1,5-naphthalenedicarboxylic acid, 2,6-naphthalenedicarboxylic acid, 1,8-naphthalenedicarboxylic acid, 4,4'-diphenyldicarboxylic acid, 4,4'-diphenyl ether dicarboxylic acid, 5-sodium sulfoisophthalic acid, phenylindane dicarboxylic acid, anthracene dicarboxylic acid, phenanthrene dicarbon, 9,9'-bis(4-carboxyphenyl) fluorene acid, or ester derivatives thereof.

Examples of the diol component (B) include diol compounds such as aliphatic diols such as ethylene glycol, 1,2-propanediol, 1,3-propanediol, 1,4-butanediol, 1,2-butanediol, and 1,3-butanediol; alicyclic diols such as a cyclohexanedimethanol, spiroglycol, and isosorbide; and aromatic diols such as bisphenol A, 1,3-benzenedimethanol, 1,4-benzenedimethanol, and 9,9'-bis(4-hydroxyphenyl) fluorene.

As the dicarboxylic acid component (A), at least one kind of aromatic dicarboxylic acid is preferably used. More preferably, among dicarboxylic acid components, the aromatic dicarboxylic acid is contained as a main component. The "main component" represents that a proportion in the dicarboxylic acid component occupied by the aromatic dicarboxylic acid is 80% by mass or more. A dicarboxylic acid component other than the aromatic dicarboxylic acid may be contained. Examples of this dicarboxylic acid component include ester derivatives of aromatic dicarboxylic acids and the like.

In addition, as the diol component (B), at least one kind of aliphatic diol is preferably used. As an aliphatic diol, ethylene glycol may be contained, and preferably ethylene glycol is contained as a "main component". In addition, the "main component" represents that a proportion in the diol component occupied by ethylene glycol is 80% by mass or more.

It is preferable that a used amount of aliphatic diol (for example, ethylene glycol) be within a range of 1.015 to 1.50 moles based on 1 mole of aromatic dicarboxylic acid (for example, terephthalic acid) and an ester derivative thereof as necessary, more preferably within a range of 1.02 to 1.30 moles, and still more preferably within a range of 1.025 to 1.10 moles. When the used amount is within a range of 1.015 moles or more, the esterification reaction progresses in a preferable manner, and when the used amount is within a range of 1.50 moles or less, for example, a byproduct of diethylene glycol from dimerization of ethylene glycol is suppressed, and thus various characteristics such as a melting point or a glass transition temperature, crystallinity, heat resistance, hydrolysis resistance, and weather resistance may be maintained in a preferable manner.

In the esterification reaction and/or transesterification reaction, a reaction catalyst that is known in the related art may be used. Examples of the reaction catalyst include an alkali metal compound, an alkaline earth metal compound, a zinc compound, a lead compound, a manganese compound, a cobalt compound, an aluminum compound, an antimony compound, a titanium compound, a phosphorus compound, and the like. Generally, it is preferable to add an antimony compound, a germanium compound, and a titanium compound as a polymerization catalyst in an arbitrary step before production of polyester is completed. As this method, for example, in the case of a germanium compound, it is preferable that a germanium compound powder be added in as is.

For example, in an esterification reaction process, an aromatic dicarboxylic acid and an aliphatic diol are polymerized in the presence of a catalyst containing a titanium compound. In this esterification reaction process, as the titanium compound that is a catalyst, an organic chelate titanium complex in which an organic acid is a ligand is used, and in the process, at least a process of adding the organic chelate titanium complex, a magnesium compound, and pentavalent phosphate ester not having an aromatic ring as a substituent group in this order is provided.

First, an aromatic dicarboxylic acid and an aliphatic diol are mixed with a catalyst containing an organic chelate titanium complex that is a titanium compound before adding a magnesium compound and a phosphorus compound. The titanium compound such as the organic chelate titanium complex has high catalytic activity with respect to an esterification reaction, and thus the esterification reaction may be performed in a preferable manner. At this time, the titanium compound may be added to a mixture of a dicarboxylic acid component and a diol component, and the diol component (or dicarboxylic acid component) may be mixed in after mixing the dicarboxylic acid component (or diol component) and the titanium compound. In addition, the dicarboxylic acid component, the diol component, and the titanium compound may be mixed simultaneously. A method of this mixing is not particularly limited, and may be performed by a known method in the related art.

Examples of more preferable polyester include polyethylene terephthalate (PET) and polyethylene-2,6-naphthalate (PEN), and PET is still more preferable. Furthermore, it is preferable that PET be polymerized by using one kind or two kinds or more selected from a group consisting of a germanium (Ge)-based catalyst, an antimony (Sb)-based catalyst, an aluminum (Al)-based catalyst, and a titanium (Ti)-based catalyst, and Ti-based catalyst is more preferably used.

The Ti-based catalyst has high reaction activity and may lower a polymerization temperature. Therefore, particularly, polyester can be prevented from being thermally decomposed during a polymerization reaction and COOH can be prevented from being generated. That is, when the Ti-based catalyst is used, an amount of terminal carboxylic acid of polyester that is a cause of the thermal decomposition may be reduced and thus formation of foreign matter may be suppressed. When the amount of the terminal carboxylic acid of polyester is reduced, thermal decomposition of polyester film after a polyester film is manufactured may be suppressed.

As the Ti-based catalyst, oxides, hydroxides, alkoxides, carboxylates, carbonates, oxalates, organic chelate titanium complexes, and halides, and the like may be exemplified. In regard to the Ti-based catalyst, two kinds or more of titanium compounds may be used in combination as long as the titanium compounds are used within a range not deteriorating an effect of the invention.

Examples of the Ti-based catalyst include titanium alkoxides such as tetra-n-propyl titanate, tetra-i-propyl titanate, tetra-n-butyl titanate, tetra-n-butyl titanate tetramer, tetra-t-butyl titanate, tetracyclohexyl titanate, tetraphenyl titanate, and tetrabenzyl titanate, titanium oxide that is obtained by hydrolysis of titanium alkoxide, titanium-silicon or zirconium composite oxide that is obtained by hydrolysis of a mixture of titanium alkoxide and silicon alkoxide or zirconium alkoxide, titanium acetate, titanium oxalate, titanium potassium oxalate, sodium titanium oxalate, potassium titanate, sodium titanate, a mixture of titanic acid and aluminum hydroxide, titanium chloride, a mixture of titanium chloride and aluminum chloride, acetylacetonato titanium, organic chelate titanium complexes in which an organic acid is a ligand, and the like.

During polymerizing polyester, it is preferable that the titanium (Ti) compound as a catalyst be used in a range of 1 to 50 ppm in a converted value for elemental titanium to perform polymerization, more preferably 2 to 30 ppm, and still more preferably 3 to 15 ppm. In this case, 1 to 50 ppm of elemental titanium is contained in a raw material resin of polyester.

When an amount of elemental titanium that is contained in the polyester raw material resin is 1 ppm or more, a weight-average molecular weight (Mw) of polyester is increased, and thus it is not likely to be thermally decomposed. Therefore, foreign matter in an extruder is reduced. When the amount of elemental titanium that is contained in the polyester raw material resin is 50 ppm or less, the Ti-based catalyst is not likely to be foreign matter, and stretching unevenness during stretching of the polyester sheet is reduced.

[Titanium Compound]

It is preferable that at least one kind of an organic chelate titanium complex in which an organic acid is a ligand be used as the titanium compound that is a catalyst component. Examples of the organic acid include citric acid, lactic acid, trimellitic acid, malic acid, and the like. Among these, the organic chelated complex in which citric acid or citrate is a ligand is preferable.

For example, when using the chelate titanium complex in which the citric acid is a ligand, polyester in which generation of foreign matter such as a fine particles is lower, and which has a satisfactory polymerization activity and color tone compared to other titanium compounds may be obtained. Furthermore, even in a case where citric acid chelate titanium complex is used, polyester, which is excellent in polymerization activity and color tone and which has fewer terminal carboxy groups may be obtained by a method of adding the complex at an esterification stage compared to a case of performing the addition after the esterification reaction. In regard to this point, the following is assumed. The titanium catalyst also has a catalyst effect for the esterification reaction, and when this titanium catalyst is added at the esterification stage, an oligomer acid value is lowered when the esterification reaction is terminated and thus the subsequent polycondensation reaction is performed in a relatively effective manner. Furthermore, the complex in which the citric acid is a ligand has hydrolysis resistance higher than that of titanium alkoxide or the like, is not hydrolyzed during the esterification reaction, and functions effectively as a catalyst of the esterification and polycondensation reaction while maintaining intrinsic activity.

In addition, generally, it is known that as a quantity of the terminal carboxylic groups increases, the hydrolysis resistance is deteriorated. Therefore, when the quantity of the terminal carboxylic groups becomes fewer according to the above-described addition method, it is expected that the hydrolysis resistance will be improved.

The citric acid chelate titanium complex may be easily available, for example, as a commercially available product such as VERTEC AC-420 manufactured by Johnson Matthey.

The aromatic dicarboxylic acid and the aliphatic diol may be introduced by preparing a slurry containing these and by continuously introducing this slurry during the esterification reaction process.

In addition, general examples of the titanium compound include oxides, hydroxides, alkoxides, carboxylates, carbonates, oxalates, halides, and the like, in addition to the organic chelate titanium complexes. In addition to the organic chelate titanium complex, another titanium compound may be used in a combination within a range not deteriorating an effect of the invention.

Examples of this titanium compound include titanium alkoxides such as tetra-n-propyl titanate, tetra-i-propyl titanate, tetra-n-butyl titanate, tetra-n-butyl titanate tetramer, tetra-t-butyl titanate, tetracyclohexyl titanate, tetraphenyl titanate, and tetrabenzyl titanate, titanium oxide that is obtained by hydrolysis of titanium alkoxide, titanium-silicon or zirconium composite oxide that is obtained by hydrolysis of a mixture of titanium alkoxide and silicon alkoxide or zirconium alkoxide, titanium acetate, titanium oxalate, titanium potassium oxalate, sodium titanium oxalate, potassium titanate, sodium titanate, a mixture of titanic acid and aluminum hydroxide, titanium chloride, a mixture of titanium chloride and aluminum chloride, acetylacetonato titanium, and the like.

In the invention, it is preferable that polyester be produced by a method of producing polyester, which includes an esterification reaction process including at least a process of polymerizing the aromatic dicarboxylic acid and the aliphatic diol in the presence of a catalyst containing a titanium compound and of adding an organic chelate titanium complex as an organic chelate titanium complex in which a ligand of at least one kind of the titanium compound is an organic acid, an organic chelate complex, a magnesium compound, and pentavalent phosphate ester not having an aromatic ring as a substituent group in this order, and a polycondensation process of polycondensing an esterification reaction product generated by the esterification reaction process to generate a polycondensate.

In this case, in the esterification reaction process, when the magnesium compound and a specific pentavalent phosphorus compound are added in this order in the presence of the organic chelate titanium complex as a titanium compound, reaction activity of the titanium catalyst is maintained to be appropriately high, and a decomposition reaction in the polycondensation may be effectively suppressed while applying an electrostatic application characteristic due to magnesium. As a result, polyester in which coloring is less, which has a high electrostatic application characteristic, and in which xanthochromic color is improved when being exposed to a high temperature may be obtained.

Due to this, coloring during polymerization and the subsequent coloring during melting and forming a film becomes less, and thus a yellow color is diminished compared to an antimony (Sb) catalyst-based polyester in the related art. Furthermore, polyester, which has a color tone and transparency comparable to a germanium catalyst-based polyester in which transparency is relatively high, and which is excellent in heat resistance, may be provided. In addition, it is possible to obtain polyester in which a cobalt compound and a color tone adjusting agent such as a pigment are not used, and thus transparency is high and a yellow color is diminished.

This polyester may be used for a use in which transparency is highly required (for example, an optical film, an industrial varnish, and the like), and since it is not necessary to use an expensive germanium-based catalyst, the cost may be significantly reduced. Furthermore, since mixing-in of catalyst-derived foreign matter that tends to be generated in the Sb-based catalyst is avoided, occurrence of a breakdown or inferior quality during a film forming process is reduced, and thus cost reduction due to improvement in a yield may be achieved.

During the esterification reaction, it is preferable to have a process of adding the organic chelate titanium complex that is a titanium compound and a magnesium compound and a pentavalent phosphorus compound as additives in this order. At this time, the esterification reaction is made to progress in the presence of the organic chelate titanium complex, and then the addition of the magnesium compound may be initiated before the addition of the phosphorus compound.

[Phosphorus Compound]

As the pentavalent phosphorus compound, at least one kind of pentavalent phosphate ester not having an aromatic ring as a substituent group is used. For example, a phosphate ester having a lower alkyl group, which has 2 or less carbon atoms, as a substituent group $[(OR)_3\text{-}P\text{=}O$: R is an alkyl group having 1 or 2 carbon atoms] may be exemplified, and specifically, trimethyl phosphate and triethyl phosphate are particularly preferable.

As an added amount of the phosphorus compound, an amount in which a converted value of elemental P is within a range of 50 to 90 ppm is preferable, more preferably 60 to 80 ppm, and still more preferably 60 to 75 ppm.

[Magnesium Compound]

When a magnesium compound is contained in polyester, an electrostatic application property of polyester is improved. In this case, there is a tendency to be colored, but in this invention, the coloring is suppressed and thus a color tone and heat resistance that are excellent may be obtained.

As the magnesium compound, magnesium salts such as magnesium oxide, magnesium hydroxide, magnesium alkoxide, magnesium acetate, and magnesium carbonate may be exemplified. Among these, magnesium acetate is most preferable from the viewpoints of solubility in ethylene glycol.

As an added amount of the magnesium compound, an amount in which a converted value of elemental Mg is 50 ppm or more is preferable to apply a high electrostatic application property, and more preferably within a range of 50 to 100 ppm. From the viewpoints of applying the electrostatic application property, it is preferable that the added amount of the magnesium compound be within a range of 60 to 90 ppm, and more preferably within a range of 70 to 80 ppm.

In the esterification reaction process, a case in which the titanium compound that is a catalyst component, and the magnesium compound and the phosphorus compound that are additives are added in such a manner that a value Z calculated by the following Formula (i) satisfies the following Relational Formula (ii) and the resultant mixture is melted and polymerized is particularly preferable. Here, a P content is an amount of phosphorus that is derived from the entirety of phosphorus compounds including pentavalent phosphate ester not having an aromatic ring, and a Ti content is an amount of titanium that is derived from the entirety of Ti compounds including an organic chelate titanium complex. In this manner, when the magnesium compound and the phosphorus compound are used in combination for the catalyst system including the titanium compound, and an addition timing and an addition proportion are controlled, a color tone in which a yellow color is diminished may be obtained while maintaining catalyst activity of the titanium compound at an appropriately high value. Therefore, heat resistance, which is not likely to cause yellow coloration even when the polyester is exposed to a high temperature during a polymerization reaction or the subsequent film formation (during melting), may be obtained.

$$Z = 5 \times (\text{P content [ppm]/atomic weight of P}) - 2 \times (\text{Mg content[ppm]/atomic weight of Mg}) - 4 \times (\text{Ti content [ppm]/atomic weight of Ti}) \cdots \text{Formula (i)}$$

$$0 \leq Z \leq +5.0 \cdots \text{Relational Formula (ii)}$$

Since the phosphorus compound reacts with the titanium and interacts with the magnesium compound, these formulas become indexes of expressing valance between the phosphorus compound, the titanium, and the magnesium compound.

Formula (i) represents an amount of phosphorus that is capable of acting with titanium while excluding a portion of phosphorus that acts with the magnesium from the total amount of phosphorus that is reactable. In a case where a value of Z is a positive value, it can be said that an amount of phosphorus, which blocks titanium, is in an excessive state. Conversely, in a case where a value of Z is a negative value, it can be said that an amount of phosphorus, which blocks titanium, is in a deficient state. In regard to reaction, each one atom of Ti, Mg, and P does not have the same equivalence, and thus each of the number of moles is multiplied by a valence.

In the invention, polyester, which is excellent in color tone and coloring resistance with respect to heat while having reaction activity that is necessary for reaction, may be obtained by using the titanium compound, the phosphorus compound, and the magnesium compound, in which special synthesis or the like is not necessary and which are cheaply and easily available.

In Formula (ii), a case in which $+1.0 \leq Z \leq +4.0$ is satisfied is preferable from the viewpoints of increasing the color tone and the coloring resistance with respect to heat while maintaining polymerization reactivity, and more preferably $+1.5 \leq Z \leq +3.0$.

As a preferable aspect of the invention, there are an aspect of adding citric acid or a chelate titanium complex in which citrate is a ligand in an amount in which a converted value of elemental Ti is 1 to 30 ppm to an aromatic dicarboxylic acid and an aliphatic diol before an esterification reaction is terminated, of adding a weak acid magnesium salt in the presence of the chelate titanium complex in an amount in which a converted value of elemental Mg is 60 to 90 ppm (more preferably, 70 to 80 ppm) after the addition of the chelate titanium complex, and of adding a pentavalent phosphate ester not having an aromatic ring as a substituent group in an amount in which a converted value of elemental P is 60 to 80 ppm (more preferably, 65 to 75 ppm) after the addition of the weak acid magnesium salt.

In the above-described configuration, it is preferable to add 70% by mass or more of the entire added amount of the chelate titanium complex (organic titanium complex), the magnesium salt (magnesium compound), and the pentavalent phosphate ester in this order, respectively.

The esterification reaction may be performed by using a multi-stage device in which at least two reactors are connected in series while removing water or alcohol generated by reaction to the outside of a system under a condition in which ethylene glycol is refluxed.

In addition, the esterification reaction may be performed in a single stage or may be separately performed in multiple stages.

In the case of performing the esterification reaction in a single stage, it is preferable that an esterification reaction temperature be 230 to 260°C, and more preferably 240 to 250°C.

In the case of separately performing the esterification reaction in multiple stages, it is preferable that an esterification reaction temperature of a first reaction tank be 230 to 260°C, and more preferably 240 to 250°C. Furthermore, it is preferable that a pressure of the first reaction tank be 1.0 to 5.0 kg/cm$^2$, and more preferably 2.0 to 3.0 kg/cm$^2$. In addition, it is preferable that an esterification reaction temperature of a second reaction tank be 230 to 260°C, and more preferably 245 to 255°C. Furthermore, it is preferable that a pressure of the second reaction tank be 0.5 to 5.0 kg/cm$^2$, and more preferably 1.0 to 3.0 kg/cm$^2$. In addition, in the case of separately performing the esterification reaction in three stages, it is preferable that esterification reaction conditions of an intermediate stage be set to conditions between the first reaction tank and the final reaction tank.

- Polycondensation -

In the polycondensation, an esterification reaction product that is generated by the esterification reaction is polycondensed to generate polycondensate. The polycondensation reaction may be performed in a single stage or may be separately performed in multiple stages.

An esterification reaction product such as an oligomer that is generated by the esterification reaction is subsequently supplied for a polycondensation reaction. This polycondensation reaction may be appropriately performed by supplying the reaction product to multi-stage polycondensation reaction tanks.

For example, in the case of performing the polycondensation reaction with three-stage reaction tanks, as polycondensation reaction conditions, it is preferable that a reaction temperature of a first reaction tank be 255 to 280°C, and more preferably 265 to 275°C. Furthermore, it is preferable that a pressure of the first reaction tank be 100 to 10 Torr ($13.3 \times 10^{-3}$ to $1.3 \times 10^{-3}$ MPa), and more preferably 50 to 20 Torr ($6.67 \times 10^{-3}$ to $2.67 \times 10^{-3}$ MPa). In addition, it is preferable that a reaction temperature of a second reaction tank be 265 to 285°C, and more preferably 270 to 280°C. Furthermore, it is preferable that a pressure of the second reaction tank be 20 to 1 Torr ($2.67 \times 10^{-3}$ to $1.33 \times 10^{-4}$ MPa), and more preferably 10 to 3 Torr ($1.33 \times 10^{-3}$ to $4.0 \times 10^{-4}$ MPa). In addition, it is preferable that a pressure of third reaction tank that is a final reaction tank be 270 to 290°C, and more preferably 275 to 285°C. Furthermore, it is preferable that a pressure of the third reaction tank be 10 to 0.1 Torr ($1.33 \times 10^{-3}$ to $1.33 \times 10^{-5}$ MPa), and more preferably 5 to 0.5 Torr ($6.67 \times 10^{-4}$ to $6.67 \times 10^{-5}$ MPa).

The polyester that is synthesized as described above may further contain additives such as an optical stabilizer, an antioxidant, an ultraviolet absorbing agent, a flame retardant, a smoothing agent (fine particles), a nucleating agent (crystallization agent), and an anti-crystallization agent.

It is preferable that polyester that is a raw material of a polyester sheet be a pellet that is polymerized in a solid-phase.

When the polyester is polymerized in a solid phase after being polymerized by an esterification reaction, a water content and crystallinity of a polyester film, an acid value (AV) of polyester, that is, a concentration of a terminal carboxy group of polyester, and an intrinsic viscosity (IV) may be controlled.

As described above, it is preferable that the intrinsic viscosity (IV) of polyester be 0.70 to 0.80 dL/g from the viewpoints of the hydrolysis resistance of the polyester film, and more preferably 0.70 to 0.76 dL/g. Particularly, when in the esterification reaction, a Ti catalyst is used and solid-phase polymerization is further performed to set the intrinsic viscosity (IV) of the polyester to 0.70 to 0.80 dL/g, crystallization of the polyester is easily suppressed in a cooling process of a molten resin of a process of manufacturing a polyester sheet.

Therefore, it is preferable that the intrinsic viscosity of polyester, which is a raw material of a polyester film that is applied to longitudinal stretching and transverse stretching, be 0.70 to 0.80 dL/g. Furthermore, it is more preferable to contain titanium atoms that are derived from a catalyst (Ti catalyst).

A method of obtaining the intrinsic viscosity (IV) is as described above.

Polyester that is polymerized by the above-described esterification reaction or commercially available polyester may be used as a starting material for the solid-phase polymerization of polyester after being shaped into a small piece form such as a pellet form.

The solid-phase polymerization of polyester may be performed by a continuous method (a method in which a resin is filled in a tower, the resin is left as is for a predetermined time while being heated, and the resin is sequentially discharged), or a batch method (a method in which a resin is put into a vessel and the resin is heated for a predetermined time).

The solid-phase polymerization is preferably performed in vacuum or in a nitrogen atmosphere.

It is preferable that a solid-phase polymerization temperature of polyester be 150 to 250°C, more preferably 170 to 240°C, and still more preferably 180 to 230°C. When the temperature is within the above-described range, the acid value (AV) of polyester is further reduced and thus this is preferable.

In addition, it is preferable that the solid-phase polymerization time be 1 to 100 hours, more preferably 5 to 100 hours, still more preferably 10 to 75 hours, and particularly preferably 15 to 50 hours. When the solid-phase polymerization time is within the above-described range, the acid value (AV) and the intrinsic viscosity (IV) of polyester may be easily controlled to be within a preferable range.

Melt extrusion

In the sheet forming process of the invention, the polyester raw material resin that is obtained as described above is melted and extruded, and is further cooled to form a polyester sheet.

The melt extrusion of the polyester raw material resin is performed, for example, by heating the polyester raw material resin to a temperature of a melting point or more and rotating screws by using an extruder provided with one or two or more screws. The polyester raw material resin is melted in the extruder due to the heating and kneading by the screws to form a melt. In addition, from the viewpoints of suppressing thermal decomposition (hydrolysis of polyester) in the extruder, it is preferable that an atmosphere in the extruder be substituted with nitrogen and then the melt extrusion of the polyester raw material resin be performed.

The melted polyester raw material resin (melt) is extruded from an extrusion die through a gear pump, a filter, and the like. The extrusion die is also referred to as simply "die" [refer to JIS B8650: 2006, a) extruder, No. 134].

At this time, the melt may be extruded in a single layer or may be extruded in multiple layers.

By extruding the melt (polyester) from the die onto a casting drum, film formation (casting) into a sheet form may be performed.

It is preferable that the thickness of a sheet-shaped polyester film body that is obtained by the casting be 0.5 to 5 mm, more preferably 0.7 to 4.7 mm, and still more preferably 0.8 to 4.6 mm.

When the thickness of the sheet-shaped polyester film body is set to 5 mm or less, cooling delay due to heat accumulation of the melt may be avoided. Furthermore, when the thickness is set to 0.5 mm or more, OH groups and COOH groups in polyester are diffused to the inside of polyester between the extrusion and the cooling, and thus exposure of the OH groups and the COOH group, which cause occurrence of hydrolysis, to a surface of polyester is suppressed.

Means for cooling the melt that is extruded from the extrusion die is not particularly limited, and a cold airflow may be blown over the melt, the melt may be brought into contact with the casting drum (cooled casting drum), or water may be sprayed on the melt. The cooling means may be used alone, or two or more thereof may be used in combination.

Among these, at least one of the cooling by cold airflow and the cooling using the casting drum is preferable from the viewpoints of preventing oligomers from being adhered to a sheet surface during a continuous operation. In addition, it is particularly preferable to cool the melt that is extruded from the extruder with cold airflow and to bring the melt into contact with the casting drum.

In addition, the polyester film body that is cooled by using the casting drum or the like is stripped from a cooling member such as the casting drum by using a stripping member such as a stripping roll.

[Longitudinal Stretching Process]

In the longitudinal stretching process of the invention, the thermoplastic resin sheet (preferably, polyester resin sheet) that is formed in the sheet forming process is longitudinally stretched in a longitudinal direction.

The longitudinal stretching of the sheet may be performed, for example, by making the sheet pass through a pair of nip rolls between which the sheet is interposed, and by applying tension between two pairs or more of nip rolls that are arranged in a sheet conveyance direction while conveying the sheet in a longitudinal direction of the sheet. Specifically, for example, when a pair of nip rolls A is provided upstream in the sheet conveyance direction and a pair of nip rolls B is provided downstream in the sheet conveyance direction, the sheet is stretched in the conveyance direction (MD; Machine Direction) by making a rotational speed of the downstream side nip rolls B faster than that of the upstream side nip rolls A when conveying the sheet. In addition, two pairs or more of nip rolls may be independently provided at the upstream side and the downstream side, respectively. In addition, the longitudinal stretching of the thermoplastic resin sheet may be performed by using a longitudinal stretching apparatus provided with the nip rolls.

In the longitudinal stretching process, it is preferable that a longitudinal stretching magnification of the thermoplastic resin sheet be 2 to 5 times, more preferably 2.5 to 4.5 times, and still more preferably 2.8 to 4 times.

In addition, an area stretching magnification expressed by a product of longitudinal and transverse stretching magnifications is preferably 6 to 18 times an area of the thermoplastic resin sheet before being stretched, more preferably 8 to 17.5 times, and still more preferably 10 to 17 times.

When a glass transition temperature of the thermoplastic resin sheet is set to Tg, it is preferable that a longitudinal temperature during stretching the thermoplastic resin sheet (hereinafter, referred to as a "longitudinal stretching temperature") be Tg-20 to Tg+50°C, more preferably Tg-10 to Tg+40°C, and still more preferably Tg to Tg+30°C.

In addition, in the case of performing the stretching by using rolls such as nip rolls as means for heating the thermoplastic resin sheet, when a heater or a pipe through which a warm solvent may flow is provided inside the rolls, the thermoplastic resin sheet, which comes into contact with the rolls, may be heated. In addition, even in the case of not using the rolls, the thermoplastic resin sheet may be heated by blowing a warm airflow to the thermoplastic resin sheet, by bringing the thermoplastic resin sheet into contact with a heat source such as a heater, or by making the thermoplastic resin sheet pass through the vicinity of the heat source.

In the method of manufacturing a biaxially stretched thermoplastic resin film of the invention, the above-described transverse stretching process is included in addition to the longitudinal stretching process. Therefore, in the method of manufacturing a biaxially stretched thermoplastic resin film of the invention, the thermoplastic resin sheet is stretched in at least two axes including a longitudinal direction (conveyance direction, MD) of the thermoplastic resin sheet and a direction (TD; Transverse Direction) that is orthogonal to the longitudinal direction of the thermoplastic resin sheet. The stretching in the MD direction and the TD direction may be performed at least one time, respectively.

In addition, the "direction (TD) that is orthogonal to the longitudinal direction (conveyance direction, MD) of the thermoplastic resin sheet" is intended to represent a direction of perpendicularity (90°) with respect to the longitudinal direction (conveyance direction, MD) of the thermoplastic resin sheet, but the direction (TD) includes a direction (for example, a direction of 90°±5° with respect to the MD direction) in which an angle with respect to the longitudinal direction (that is, conveyance direction) may be substantially regarded to be 90° due to a mechanical error or the like.

A biaxial stretching method may be either a sequential biaxial stretching method in which the longitudinal stretching and the transverse stretching are separately performed, or a simultaneous biaxial stretching method in which the longitudinal stretching and the transverse stretching are performed simultaneously. The longitudinal stretching and the transverse stretching may be independently performed two or more times, respectively, and the sequence of the longitudinal stretching and the transverse stretching does not matter. For example, stretching aspects such as longitudinal stretching → transverse stretching, longitudinal stretching → transverse stretching → longitudinal stretching, longitudinal stretching → longitudinal stretching → transverse stretching, and transverse stretching → longitudinal stretching may be exemplified, but among these, longitudinal stretching → transverse stretching is preferable.

<Biaxially Stretched Thermoplastic Resin Film>

The biaxially stretched thermoplastic resin film is manufactured by biaxially stretching the thermoplastic resin film according to the above-described method of manufacturing a biaxially stretched thermoplastic resin film of the invention.

As described above, the biaxially stretched thermoplastic resin film includes a film that is formed by using a thermoplastic resin such as polyester, polyethylene, polypropylene, polyvinyl chloride, polystyrene, polyacetal, polyimide, and polyamide. Among these, a film including polyester is preferable from the viewpoints of durability over a long period of time and appropriate application, for example, for a solar cell use, and a polyester film including polyethylene terephthalate (PET) as a main component is preferable. Here, the "main component" represents that a proportion of the total amount of the thermoplastic resin in the film after being stretched occupied by PET is 70% by mass or more.

The biaxially stretched thermoplastic resin film may contain additives such as a coloring pigment, a dye, and a thermal stabilizer.

In addition, the biaxially stretched thermoplastic resin film may be a multi-layer film having a multi-layer structure in which different materials are adhered to each other. Examples of the multi-layer film include a film formed by extruding the different materials together from a die, a film formed by adhering other films to each other, and a film obtained by coating different material before the transverse stretching, but is not particularly limited.

The polyester film also includes PET that is copolymerized in a polymerization stage with an isophthalic acid component, a naphthalene acid component, or the like and in addition, a blend resin that is obtained by mixing different resins in an extruder.

It is preferable that an intrinsic viscosity (IV) of the polyester film be 0.70 to 0.80 dL/g. When IV is within a relatively high range such as 0.70 dL/g or more, a molecular movement of polyester is blocked, and thus crystallization of polyester is not likely to occur. In addition, when IV is 0.80 dL/g or less, thermal decomposition of polyester due to shear heating in the extruder does not occur excessively, the crystallization is suppressed, and an acid value (AV) may be suppressed to be low.

It is preferable that the intrinsic viscosity of polyester, which is a raw material of the polyester film supplied for the longitudinal stretching and the transverse stretching, be 0.70 to 0.76 dL/g. In addition, it is preferable that this polyester further contain titanium atoms that are derived from a catalyst (Ti catalyst).

The intrinsic viscosity (IV) is a value that is obtained by extrapolating a value divided by a concentration of specific viscosity $\eta_{sp} = \eta_r$-1), which is obtained by subtracting 1 from a ratio $\eta_r$ (= $\eta/\eta_0$; relative viscosity) of solution viscosity ($\eta$) and solvent viscosity ($\eta_0$), to a state in which a concentration is zero. IV is obtained as follows. First, polyester is dissolved in a mixed solvent of 1,1,2,2-tetrachloroethane/phenol (=2/3 [mass ratio]), and then IV is obtained from solution viscosity at 25°C by using Ubbelohde type viscometer.

In addition, a thermal contraction ratio (heating condition: heating at 150°C for 30 minutes) of the biaxially stretched thermoplastic resin film (preferably, a polyester film) manufactured according to the method of the invention is set to 2.0% or less.

In general, since in a thermoplastic resin such as polyester, a thermal expansion coefficient or a hygroscopic expansion coefficient is larger than that of glass, there is a tendency for stress to be easily applied to the thermoplastic resin due to a change in temperature and humidity, and cracking or layer stripping is easily caused. When the thermal contraction ratio is set to be within a range, a functional sheet, which is adhered to the thermoplastic resin film such as a polyester film, is prevented from being peeled off and thus cracking of a layer that is applied on the film or the like is prevented. The biaxially stretched thermoplastic resin film is manufactured according to the method of manufacturing a biaxially stretched thermoplastic resin film of the invention described above, and thus the thermal contraction ratio is achieved. Particularly, the thermal contraction ratio is suppressed to 2.0% or less by controlling heating conditions ($T_{\text{thermal fixation}}$ and/or $T_{\text{thermal relaxation}}$) in the respective thermal fixation process and the thermal relaxation process of the transverse stretching process.

In the above description, it is more preferable that the thermal contraction ratio be 1.0% or less, and still more preferably 0.5% or less.

In a case where the biaxially stretched thermoplastic resin film is a polyester film, it is preferable that a content (AV) of terminal carboxyl groups be 20 equivalents/ton from the viewpoints of hydrolysis resistance, more preferably 2 to 17 equivalents/ton, and still more preferably 5 to 15 equivalents/ton or less.

AV represents an amount of the terminal carboxylic acid of polyester, and the presence of the terminal carboxylic acid represents a catalyst reaction with respect to a hydrolysis reaction of polyester. Therefore, when AV is 20 equivalents/ton or less, durability (humidity and heat resistance) may be improved. In addition, when the lower limit of AV is 2 equivalents/ton or more, adhesion with adjacent layer becomes preferable.

In addition, "equivalent/ton" represents a mole equivalent per 1 ton.

In addition, in regard to AV, polyester is completely dissolved in a mixed solution of benzyl alcohol/chloroform (=2/3: a volume ratio), phenol red is used as an indicator, titration is performed with a standard solution (0.25 N KOH-methanol mixed solution), and an amount (eq/ton) of the terminal carboxylic acid groups is calculated from a titration amount.

It is preferable that the thickness of the biaxially stretched thermoplastic resin film that is manufactured by the above-described method of manufacturing a biaxially stretched thermoplastic resin film of the invention be within a range of 30 to 400 $\mu$m after the transverse stretching process. When the thickness is within this range, this is advantageous from the viewpoints of an electrical insulation property. It is more preferable that the thickness of the biaxially stretched thermoplastic resin film be 40 to 350 $\mu$m from the viewpoints of the electrical insulation property, and still more preferably 50 to 300 $\mu$m.

In addition, in a case where the biaxially stretched thermoplastic resin film is a polyester film, it is preferable that the thickness after the transverse stretching process be 180 $\mu$m or more from the viewpoints of hydrolysis resistance, more preferably 180 to 400 $\mu$m, still more preferably 180 to 350 $\mu$m, further still more preferably 200 to 320 $\mu$m, particularly more preferably 200 to 290 $\mu$m. When the film is formed to be relatively thick such as 180 $\mu$m or more, hydrolysis resistance tends to deteriorate, but according to the invention, the hydrolysis resistance becomes excellent.

<Back Sheet for Solar Cell>

A back sheet for a solar cell is configured by providing the above-described biaxially stretched thermoplastic resin film, and may be configured by further providing functional layers such as an easy adhesive layer having an easy adhesion property with respect to an adhered material, an ultraviolet absorbing layer, and an optical reflective white layer to this biaxially stretched thermoplastic resin film. When the back sheet is provided with the above-described biaxially stretched thermoplastic resin film (particularly, polyester film), the back sheet exhibits stable durability when being used over a long period of time.

In the back sheet for a solar cell, the biaxially stretched thermoplastic resin film (for example, the polyester film after biaxial stretching) is coated with the following functional layer. A known application technology such as a roll coat method, a knife edge coat method, a gravure coat method, and a curtain coat method may be used for the coating.

In addition, before the coating, a surface treatment (a flame treatment, a corona treatment, a plasma treatment, an ultraviolet treatment, and the like) may be performed. Furthermore, adhesion using an adhesive may be preferably performed.

- Easy Adhesive Layer -

When making up a solar cell module, the back sheet for a solar cell is preferably provided with an easy adhesive layer at a side, which is opposite to a sealing material of a battery side substrate in which a solar cell element is sealed with the sealing material, of the biaxially stretched thermoplastic resin film. When the easy adhesive layer, which exhibits adhesiveness with respect to an adhered material including the sealing material (particularly, ethylene-vinyl acetate copolymer (EVA) (for example, with respect to a surface of the sealing material of the battery side substrate in which the solar cell element is sealed with the sealing material), is provided, the back sheet and the sealing material may be strongly adhered to each other. Specifically, it is preferable that the easy adhesive layer have an adhesive force of 10 N/cm or more with the EVA (ethylene-vinyl acetate copolymer) that is used as the sealing material, and more preferably 20 N/cm or more.

Furthermore, it is necessary for the easy adhesive layer not to cause peeling-off of the back sheet during using of the solar cell module. Therefore, it is preferable for the easy adhesive layer to have high humidity and heat resistance.

(1) Binder

The easy adhesive layer may contain at least one kind of binder. As the binder, for example, polyester, polyurethane, an acrylic resin, polyolefin, or the like may be used. Among these, the acrylic resin and polyolefin are preferable from the viewpoints of durability. In addition, a composite resin of acryl and silicone is also preferable as the acrylic resin. As preferable examples of the binder, the following materials may be exemplified.

Examples of the polyolefin include CHEMIPEARL S-120 and S-75N (trade names, all manufactured by Mitsui Chemicals, Inc.). Examples of the acrylic resin include JURYMER ET-410 and SEK-301 (trade names, all manufactured by Nihon Junyaku Co., Ltd.). In addition, examples of the composite resin of acryl and silicone include CERANATE WSA1060 and WSA 1070 (trade names, all manufactured by DIC Corp.), and H7620, H7630, and H7650 (trade names, all manufactured by Asahi Kasei Chemicals Corp.).

It is preferable a content of the binder be within a range of 0.05 to 5 g/m$^2$, and more preferably within a range of 0.08 to 3 g/m$^2$. When the content of the binder is 0.05 g/m$^2$ or more, a relatively satisfactory adhesive force may be obtained, and when the content is 5 g/m$^2$ or less, a relatively satisfactory surface state may be obtained.

Fine Particles

The easy adhesive layer may contain at least one kind of fine particles. It is preferable that the easy adhesive layer contain 5% by mass or more of fine particles based on the total mass of the layer.

Suitable examples of the fine particles include inorganic fine particles of silica, calcium carbonate, magnesium oxide, magnesium carbonate, tin oxide, and the like. Among these, fine particles of tin oxide and silica are preferable from the viewpoints that a decrease in adhesiveness is small when being exposed to a humid and hot atmosphere.

It is preferable that a particle size of the fine particles be approximately 10 to 700 nm, and more preferably approximately 20 to 300 nm. When using fine particles having a particle size within the range, satisfactory easy adhesiveness may be obtained. There is no particular limitation on a shape of the fine particles, and fine particles of a spherical form, an amorphous form, a needle-like form, or the like may be used.

It is preferable that an added amount of the fine particles in the easy adhesive layer be 5 to 400% by mass based on the binder in the easy adhesive layer, and more preferably 50 to 300% by mass. When the added amount of the fine particles is 5% by mass or more, adhesiveness is excellent when being exposed to a humid and hot atmosphere, and when the added amount is 1000% by mass or less, a surface state of the easy adhesive layer becomes relatively satisfactory.

(3) Crosslinking Agent

The easy adhesive layer may contain at least one kind of crosslinking agent. Examples of the crosslinking agent include epoxy-based crosslinking agent, isocyanate-based crosslinking agent, melamine-based crosslinking agent, carbodiimide-based crosslinking agent, and oxazoline-based crosslinking agent. Among these, from the viewpoints of securing adhesiveness after passage of time under the humid and hot atmosphere, oxazoline crosslinking agents are particularly preferable.

Specific examples of the oxazoline-based crosslinking agent include 2-vinyl-2-oxazoline, 2-vinyl-4-methyl-2-oxazoline, 2-vinyl-5-methyl-2-oxazoline, 2-isopropenyl-2-oxazoline, 2-isopropenyl-4-methyl-2-oxazoline, 2-isopropenyl-5-ethyl-2-oxazoline, 2,2'-bis(2-oxazoline), 2,2'-methylene-bis(2-oxazoline), 2,2'-ethylene-bis(2-oxazoline), 2,2'-trimethylene-bis(2-oxazoline), 2,2'-tetramethylene-bis(2-oxazoline), 2,2'-hexamethylene-bis(2-oxazoline), 2,2'-octamethylene-bis(2-oxazoline), 2,2'-ethylene-bis(4,4'-dimethyl-2-oxazoline), 2,2'-p-phenylene-bis(2-oxazoline), 2,2'-m-phenylene-bis(2-oxazoline), 2,2'-m-phenylene-bis(4,4'-dimethyl-2-oxazoline), bis(2-oxazolinylcyclohexane) sulfide, bis(2-oxazolinylnorbonane) sulfide, and the like. Furthermore, (co)polymers of these compounds may also be preferably used. In addition, as the oxazoline-based crosslinking agent, for example, commercially available EPOCROS K2010E, EPOCROS K2020E, EPOCROSS K2030E, EPOCROSS WS500 and EPOCROSS WS700 (trade names, all manufactured by Nippon Shokubai Co., Ltd.), and the like may be used.

It is preferable that an added amount of the crosslinking agent in the easy adhesive layer be 5% to 50% by mass based on the content of the binder in the easy adhesive layer, and more preferably 20% to 40% by mass. When the added amount of the crosslinking agent is 5% by mass or more, satisfactory crosslinking effects are obtained, and a decrease in the strength or adhesive failure of a reflective layer are difficult to occur. When the content is 50% by mass or less, the pot life of coating liquid may be maintained relatively long.

(4) Additive

In the easy adhesive layer according to the invention, known surfactants matting agents such as polystyrene, polymethyl methacrylate, and silica, known surfactants of an anionic type or a nonionic type, and the like may be further added as necessary.

(5) Method of Forming Easy Adhesive Layer and Property

A method of adhering a polymer sheet having easy adhesiveness to a biaxially stretched thermoplastic resin film or an application method is applicable for formation of the easy adhesive layer. However, the application method is preferable from the viewpoints that formation of a thin film that is highly uniform may be realized in a simple manner. As the application method, for example, a known method such as a gravure coater and a bar coater may be used. A solvent that is used as application liquid, in addition to water, an organic solvent such as toluene and methyl ethyl ketone may be used.

It is preferable that the easy adhesive layer be transparent from the viewpoints of not deteriorating an effect of a colored layer in a case where the colored layer (particularly, a reflective layer) is disposed between the biaxially stretched thermoplastic resin film and the easy adhesive layer. Generally, the thickness of the easy adhesive layer is approximately 0.05 to 8 $\mu$m, and more preferably approximately 0.1 to 5 $\mu$m. When the thickness of the easy adhesive layer is 0.05 $\mu$m or more, it is easy to obtain easy adhesiveness that is necessary, and when the thickness is 8 $\mu$m or less, a surface state may be maintained in a relatively satisfactory manner.

- Ultraviolet Absorbing Layer -

In the back sheet for a solar cell, an ultraviolet absorbing layer containing an ultraviolet absorbing agent may be provided on the biaxially stretched thermoplastic resin film. The ultraviolet absorbing layer may be disposed at an arbitrary position on the biaxially stretched thermoplastic resin film.

As the ultraviolet absorbing agent, an organic ultraviolet absorbing agent and an inorganic ultraviolet absorbing agent are exemplified. Furthermore, these may be used in combination. Examples of the organic ultraviolet absorbing agent include ultraviolet absorbing agents such as a salicylic acid-based ultraviolet absorbing agent, a benzophenone-based ultraviolet absorbing agent, a benzotriazole-based ultraviolet absorbing agent, a triazine-based ultraviolet absorbing agent, and a cyanoacrylate-based ultraviolet absorbing agent, and ultraviolet stabilizers such as a hindered amine-based ultraviolet stabilizer, and the like. A triazine-based ultraviolet absorbing agent is more preferable from the viewpoints that tolerance against repetitive ultraviolet absorption is high. It is preferable to use the ultraviolet absorbing agent by dissolving and dispersing it together with an ionomer resin, a polyester resin, an urethane resin, an acrylic resin, a polyethylene resin, a polypropylene resin, a polyamide resin, a vinyl acetate resin, a cellulose ester resin, and the like. It is preferable that the ultraviolet absorbing agent make transmittance of light of 400 nm or less be 20% or less.

- Colored Layer -

The back sheet for a solar cell may be configured by providing a colored layer on the biaxially stretched thermoplastic resin film. The colored layer is a layer that is disposed to come into contact with a surface of the biaxially stretched thermoplastic resin film or that is disposed through another layer. The colored layer may be configured by using a pigment or a binder.

A first function of the colored layer is to increase the power generation efficiency of a solar cell module by reflecting a portion of light that has reached the back sheet without being used for power generation in the solar cell, in the incident light, to return the portion of light to the solar cell. A second function of the colored layer is to enhance decorativeness of the external appearance when the solar cell module is viewed from the front (surface) side. In general, when a solar cell module is viewed from the front (surface) side, a back sheet is seen around the solar cell. Therefore, when a colored layer is provided on the back sheet, decorativeness may be enhanced.

(1) Pigment

The colored layer may contain at least one kind of pigment. Examples of the pigment include inorganic pigments such as titanium oxide, barium sulfate, silicon oxide, aluminum oxide, magnesium oxide, calcium carbonate, kaolin, talc, ultramarine blue, Prussian blue, and carbon black; and organic pigments such as phthalocyanine blue and phthalocyanine green. Among these pigments, in the case of constructing the colored layer as a reflective layer which reflects incident sunlight, a white pigment is preferable. Preferable examples of the white pigment include titanium oxide, barium sulfate, silicon oxide, aluminum oxide, magnesium oxide, calcium carbonate, kaolin, talc, and the like.

An average particle size of the pigment is preferably 0.03 to 0.8 $\mu$m, and more preferably approximately 0.15 to 0.5 $\mu$m. When the average particle size is within this range, light reflection efficiency is high.

A content of the pigment is preferably 1.5 to 15 g/m$^2$ from the viewpoints that necessary coloring tends to be obtained and a surface state of a layer becomes satisfactory, and more preferably 2.5 to 8.5 g/m$^2$.

(2) Binder

The colored layer may contain at least one kind of binder. In the case of containing the binder, it is preferable that an amount of the binder be within a range of 15 to 200% by mass of the pigment, and more preferably within a range of 17 to 100% by mass. When the amount of the binder is 15% by mass or more, the strength of the colored layer is further satisfactorily maintained, and when the amount of the binder is 200% by mass or less, reflectance or decorativeness deteriorates.

As the binder that is very suitable for the colored layer, polyester, polyurethane, acrylic resins, polyolefin, and the like may be used. From the viewpoints of durability, acrylic resin and polyolefin are preferable as the binder. In addition, as the acrylic resin, a composite resin of acryl and silicone is also preferable. As a specific example of the binder, examples of polyolefin include CHEMIPEARL S-120 and S-75N (trade names, all manufactured by Mitsui Chemicals, Inc.). Examples of the acrylic resin include JURYMER ET-410 and SEK-301 (trade names, all manufactured by Nihon Junyaku Co., Ltd.). In addition, examples of the composite resin of acryl and silicone include CERANATE WSA1060 and WSA 1070 (trade names, all manufactured by DIC Corp.), and H7620, H7630, and H7650 (trade names, all manufactured by Asahi Kasei Chemicals Corp.).

(3) Additive

In addition to the binder and the pigment, a crosslinking agent, a surfactant, a filler, and the like may be further added to the colored layer as necessary.

Examples of the crosslinking agent include an epoxy-based crosslinking agent, an isocyanate-based crosslinking agent, a melamine-based crosslinking agent, a carbodiimide-based crosslinking agent, an oxazoline-based crosslinking agent, and the like. An added amount of the crosslinking agent in the colored layer is preferably 5 to 50% by mass based on the binder of the colored layer.

As the surfactant, known surfactants of an anionic type or a nonionic type, and the like may be exemplified. An added amount of the surfactant in the colored layer is preferably 0.1 to 15 mg/m$^2$.

As the filler, silica and the like that are different from the pigment may be exemplified. An added amount of the filler is preferably 20% by mass or less based on the binder of the colored layer.

(4) Method of Forming Colored Layer and Property of Color Layer

The formation of the colored layer may be performed by a method of adhering a polymer sheet containing pigment to a biaxially stretched thermoplastic resin film, a method of extruding the colored layer together at the time of forming the polyester sheet, an application method, and the like. However, the application method is preferable from the viewpoints that formation of a thin film that is highly uniform may be realized in a simple manner. As the application method, for example, a known method such as using a gravure coater and a bar coater may be used. A solvent that is used as application liquid, in addition to water, an organic solvent such as toluene and methyl ethyl ketone may be used, and water is preferable from the viewpoints of environmental load.

It is preferable that the colored layer contain a white pigment and be configured as a white layer (a light reflection layer). In this case, an optical reflectance of 550 nm is preferably 75% or more. When the reflectance is 75% or more, solar light, which passes through the solar cell and is not used for power generation, is returned to the cell, and thus the power generation efficiency is improved.

The thickness of the white layer (light reflection layer) is preferably 1 to 20 $\mu$m. When the thickness is 1 $\mu$m or more, reflectance and decorativeness, which are necessary, tend to be obtained, and when the thickness is 20 $\mu$m or less, a surface state becomes excellent.

- Undercoat Layer -

In the biaxially stretched thermoplastic resin film, an undercoat layer may be provided. For example, when the colored layer is provided, the undercoat layer may be provided between the colored layer and the biaxially stretched thermoplastic resin film. The undercoat layer may be configured by using a binder, a crosslinking agent, a surfactant, and the like.

The undercoat layer is appropriately formed by application onto the biaxially stretched thermoplastic resin film (preferably, a polyester film after the biaxial stretching). The thickness of the undercoat layer is preferably 0.05 to 2 $\mu$m.

- Fluorine-Based Resin Layer and Silicon-Based Resin Layer -

In the back sheet for a solar cell, at least one of a fluorine-based resin layer and a silicon-based (Si-based) resin layer is preferably provided on the biaxially stretched thermoplastic resin film. When the fluorine-based resin layer or the Si-based resin layer is provided, prevention of contamination on a polyester surface and weather resistance may be achieved. Specifically, it is preferable to include a fluorine resin-based coated layer described in specifications of JP2007-35694A, JP2008-28294A, and WO2007/063698. In addition, it is preferable to adhere a fluorine-based resin film such as Tetra (trade name, manufactured by DuPont Ltd.).

The thickness of the fluorine-based resin layer and the Si-based resin layer are preferably 1 to 50 $\mu$m, respectively, more preferably 1 to 40 $\mu$m, and still more preferably 1 to 10 $\mu$m.

- Inorganic Layer -

In the back sheet for a solar cell, as aspect in which an inorganic layer is provided on the biaxially stretched thermoplastic resin film is also preferable. When the inorganic layer is provided, functions of a moisture barrier property or a gas barrier property, which prevents permeation of water or gas, may be given. The inorganic layer may be provided on either a front surface or a rear surface of the biaxially stretched thermoplastic resin film, but from the viewpoints of moisture barrier or bas barrier, the organic layer is appropriately provided on a side that is opposite to a side (the colored layer or easy adhesive layer forming surface side) facing a battery side substrate of the biaxially stretched thermoplastic resin film.

It is preferable that an amount of water vapor permeation (moisture permeability) be $10^0$ to $10^{-6}$ g/m$^2$·d, more preferably $10^1$ to $10^{-5}$ g/m$^2$·d, and still more preferably $10^2$ to $10^{-4}$ g/m$^2$·d.

A dry method is appropriate for formation of the inorganic layer having this moisture permeability. Examples of a method of forming the gas-barrier inorganic layer by the dry method include vacuum vapor deposition methods such as resistance heating vapor deposition, electron beam vapor deposition, induction heating vapor deposition, and an assist method by plasma or ion beams; sputtering methods such as a reactive sputtering method, an ion beam sputtering method, and an ECR (electron cyclotron) sputtering method; physical vapor deposition method (PVD method) such as an ion plating method; a chemical vapor deposition method (CVD method) that uses heat, light, plasma, or the like; and the like. Among these, the vacuum vapor deposition method in which a film is formed by a vapor deposition method in a vacuum atmosphere is preferable.

Here, in a case where a material that forms the inorganic layer includes an inorganic oxide, an inorganic nitride, an inorganic acid nitride, an inorganic halide, an inorganic sulfide, or the like as a main constituent component, examples of method include 1) a method in which a material having the same composition as a barrier layer that is formed is used as a volatilization source, and which volatilizes this material while introducing oxygen gas in the case of inorganic oxide, nitrogen gas in the case of inorganic nitride, mixed gas of oxygen gas and nitrogen gas in the case of inorganic acid nitride, halogen-based gas in the case of inorganic halide, or sulfur-based gas in the case of inorganic sulfide to a system in an auxiliary manner, 2) a method in which an inorganic material group is used as a volatilization source, which introduces oxygen gas, nitrogen gas, mixed gas of oxygen gas and nitrogen gas, halogen-based gas, or sulfur-based gas to a system as described above while volatilizing the inorganic material group, and which deposits the inorganic material group on a surface of a base material while causing the inorganic material and the introduced gas to react with each other, 3) a method in which an inorganic material group that is used as a volatilization source is volatilized to form an inorganic material group layer, and then maintains the inorganic material group layer in an oxygen gas atmosphere in the case of inorganic oxide, in a nitrogen gas atmosphere in the case of inorganic nitride, in a mixed gas atmosphere of oxygen gas and nitrogen gas in the case of inorganic acid nitride, a halogen-based gas atmosphere in the case of inorganic halide, or in a sulfur-based gas atmosphere in the case of inorganic sulfide to cause the inorganic material layer and the gas that is introduced to react with each other, and the like.

Among these methods, from the viewpoints that the volatilization from volatilization source is easily performed, 2) or 3 is preferable. In addition, from the viewpoints that control of film quality is easy, 2) is preferable. In addition, in a case where the barrier layer is formed from an inorganic acid oxide, a method in which an inorganic material group is used as a volatilization source, this inorganic material group is volatilized to form an inorganic material group layer, and then this layer is left as is in air to cause the inorganic material group to be naturally oxidized is preferable from the viewpoints of formation easiness.

In addition, aluminum foil may be adhered as a barrier layer. The thickness is preferably 1 to 30 $\mu$m. When the thickness is 1 $\mu$m or more, water is not likely to permeate into the biaxially stretched thermoplastic resin film during the passage of time (thermo), and the hydrolysis resistance is excellent. When the thickness is 30 $\mu$m or less, the barrier layer is not too thick, and thus unevenness due to stress of the barrier layer does not occur in the film.

<Solar Cell Module>

In general, the solar cell module is configured by disposing a solar cell element, which converts light energy of solar light to electrical energy, between a transparent front substrate through which solar light enters, and the above-described biaxially stretched thermoplastic resin film (preferably, the polyester film; the back sheet for a solar cell) of the invention. As a specific embodiment, the solar cell module may be configured by an aspect in which a power generation element (solar cell element) that is connected to a lead wire (not shown) that takes out electricity is sealed with a sealing material such as an ethylene-vinyl acetate copolymer (EVA system) resin, and this sealed power generation element is interposed between a transparent substrate such as glass and the biaxially stretched thermoplastic resin film (preferably, the polyester film; the back sheet for a solar cell) to adhere these to each other.

As an example of the solar cell element, various known solar cell elements of silicon-based materials such as single-crystal silicon, poly-crystal silicon, and amorphous silicon; group III-V or Group II-VI compound semiconductors such as copper-indium-gallium-selenium, copper-indium-selenium, cadmium-tellurium, and gallium-arsenic; and the like may be applied. For example, a portion between the substrate and the biaxially stretched thermoplastic resin film is sealed with a resin (so-called sealing material) such as ethylene-vinyl acetate copolymer.

[Examples]

Hereinafter, the invention will be described in more detail with reference to examples, but the invention is not limited to the following examples as long as the gist of the invention is not departed from. In addition, when it is not particularly defined, "parts" is with respect to mass.

(Example 1)

<Synthesis of Polyester Raw Material Resin>

As described below, polyester (Ti catalyst-based PET) was obtained by a continuous polymerization apparatus by using a direct esterification method in which terephthalic acid and ethylene glycol are made to directly react with each other to distill water, and then esterification is performed, and then polycondensation is performed under decompression.

(1) Esterification Reaction

4.7 tons of terephthalic acid of high-purity and 1.8 tons of ethylene glycol were mixed in a reaction tank for 90 minutes to form a slurry, and this slurry was continuously supplied to a first esterification reaction tank at a flow rate of 3800 kg/h. Furthermore, an ethylene glycol solution of a citric acid chelate titanium complex (VERTEC AC-420 manufactured by Johnson Matthey.) in which citric acid is coordinated to Ti metal was further continuously supplied to the reaction tank, and reaction was performed in the reaction tank under reaction conditions of a temperature of 250°C and an average residence time of approximately 4.3 hours while agitating the resultant mixture. At this time, the citric acid chelate titanium complex was continuously added in such a manner that an added amount of Ti became 9 ppm in a converted value of the element. At this time, an acid value of oligomer that was obtained was 600 equivalents/ton.

This reaction product was conveyed to a second esterification reaction tank and reaction was carried out in this reaction tank at 250°C for 1.2 hours as an average residence time while agitating the reaction product to obtain oligomer having an acid value of 200 equivalents/ton. The inside of the second esterification reaction tank is divided into three zones. From a second zone, an ethylene glycol solution of magnesium acetate was continuously supplied in such a manner an added amount of Mg became 75 ppm in a converted value of the element, and from a third zone, an ethylene glycol solution of trimethyl phosphate was continuously supplied in such a manner that an added amount of P became 65 ppm in a converted value of the element.

(2) Polycondensation Reaction

The esterification reaction product obtained as described above was continuously supplied to a first polycondensation reaction tank and polycondensation was carried out at a reaction temperature of 270°C and at a pressure inside the reaction tank of 20 Torr ($2.67\times10^{-3}$ MPa) for approximately 1.8 hours as an average residence time while carrying out agitation.

Furthermore, the resultant material was conveyed to a second polycondensation reaction tank, and in this reaction tank, reaction (polycondensation) was carried out under conditions of a temperature inside the reaction tank of 276°C, a pressure inside the reaction tank of 5 Torr ($6.67\times10^{-4}$ MPa), and a residence time of approximately 1.2 hours while agitating the resultant material.

Subsequently, the resultant material was conveyed to a third polycondensation reaction tank, and in this reaction tank, reaction (polycondensation) was carried out under conditions of a temperature inside the reaction tank of 278°C, a pressure inside the reaction tank of 1.5 Torr ($2.0\times10^{-4}$ MPa), and a residence time of 1.5 hours to obtain a reaction product (polyethylene terephthalate (PET)).

Next, the obtained reaction product was ejected in a strand shape to cold water and was immediately cut to prepare polyester pellets (cross-section: long diameter of approximately 4 mm, short diameter of approximately 2 mm, and length of approximately 3 mm).

With respect to polyester that was obtained, measurement was carried out as described below by using high-frequency inductively coupled plasma mass spectrometry of high-resolution type (HR-ICP-MS; AttoM manufactured by SII Nano Technology Inc.). From the results, it was confirmed that Ti was 9 ppm, Mg was 75 ppm, and P was 60 ppm. P was slightly decreased compared to an original added amount, but it was assumed that this decrease of P was caused by volatilization during the polycondensation.

In a polymer that was obtained, IV was 0.65, an amount (AV) of terminal carboxy groups was 22 equivalents/ton, a melting point was 257°C, and solution haze was 0.3%. Measurement of IV and AV was carried out by a method to be described below.

(3) Solid-Phase Polymerization Reaction

The polyester pellets, which were obtained as described above, were subjected to a solid-phase polymerization by a batch method. Specifically, the polyester pellets were introduced to a vessel and then a preliminary crystallization treatment was carried out at 150°C while agitating the pellets in a vacuum. Then, a solid-phase polymerization reaction was carried out at 200°C for 30 hours.

In this manner, the polyester raw material resin was obtained.

<Manufacturing of Non-Stretched Polyester Sheet>

- Sheet Forming Process -

The polyester raw material resin (PET resin A) that was obtained as described above was dried to a moisture content of 20 ppm or less and then was added to a hopper of a single-axis kneading extruder having a diameter of 113 mm. The PET resin A was melted at 300°C and was extruded from a die through a gear pump and a filter (an opening diameter of 20 $\mu$m) under the following extrusion conditions.

<Extrusion Conditions>

The extrusion conditions of the melted resin were as follows. That is, a pressure variation was set to 1% and a temperature distribution of the melted resin was set to 2%.

Specifically, a back pressure in a barrel of the extruder was set to a pressure that was higher than a pressure inside the barrel of the extruder by 1%, and heating was carried out in a manner such that a pipe temperature of the extruder was set to a temperature higher than an average temperature inside the barrel of the extruder by 2%.

The melted resin was extruded from the die to a cold casting drum and was brought into close contact with the cold casting drum by using an electrostatic application method. The cooling of the melted resin was carried out in such a manner that a temperature of the cold casting drum was set to 25°C, and cold airflow of 25°C was blown from a cold airflow generating device provided opposite to the cold casting drum. The resin on the cold casting drum was peeled off from the cold casting drum by using a scraping roll that was disposed to be opposite to the cold casting drum as a non-stretched polyester sheet (non-stretched PET sheet) having the thickness of 3.5 mm.

The non-stretched PET sheet that was obtained had an intrinsic viscosity (IV) of 0.75, a concentration (AV) of terminal carboxy groups was 15.5 equivalents/ton, and a glass transition temperature (Tg) was 72°C.

<Measurement of IV and AV>

IV was obtained as follows. First, the non-stretched polyester sheet was dissolved in a mixed solvent of 1,1,2,2-tetrachloroethane/phenol (=2/3 [mass ratio]), and then IV was obtained from the solution viscosity at 25°C in the mixed solvent.

AV was obtained as follows. First, the non-stretched polyester sheet was completely dissolved in a mixed solution of benzyl alcohol/chloroform (=2/3: a volume ratio), phenol red was used as an indicator, titration was carried out with a standard solution (0.25 N KOH-methanol mixed solution), and AV was calculated from a titration amount.

Tg was obtained through measurement according to JIS K7121.

<Manufacturing of Biaxially Stretched Polyester Film>

The non-stretched PET sheet that was obtained was sequentially stretched by the following method to prepare a biaxially stretched polyester film (biaxially stretched PET film) having the thickness of 250 μm.

- Longitudinal Stretching Process -

The non-stretched PET sheet was made to pass between two pairs of nip rolls in which a peripheral speed of each pair was different and was stretched in a longitudinal direction (conveyance direction) under the following conditions.
Preheating temperature: 80°C
Longitudinal stretching temperature: 90°C
Longitudinal stretching magnification: 3.4 times
Longitudinal stretching stress: 12 MPa

- Transverse Stretching -

The longitudinally stretched PET film (longitudinally stretched PET film) was stretched by using a transverse stretching tenter having a configuration shown in Fig. 1 under the following conditions.

(Preheating Section)

Preheating temperature was set to 130°C and heating was performed to be stretchable.

(Stretching Section)

Tension was applied to the longitudinally stretched PET film, which was preheated in a film transverse direction that is orthogonal to the longitudinally stretching direction (longitudinal direction) under the following conditions to carry out the transverse stretching.

<Conditions>

- Stretching temperature (transverse stretching temperature): 140°C
- Stretching magnification (transverse stretching magnification): 4.4 times
- Stretching stress (transverse stretching stress): 18 MPa
- Film surface temperature at an exit of a stretching zone: 138°C

(Thermal Fixation Section)

A temperature of film heating airflow in the thermal fixation zone was set, an airflow velocity was adjusted, and the maximum arrival temperature ($T_{\text{thermal fixation}}$) on the film surface during thermal fixation was adjusted to a temperature (193°C) as shown in Table 1 to be described below. Here, the contraction treatment (MD contraction) in the longitudinal direction (MD) of a film was not performed.

<Thermal Fixation Condition>

Contraction ratio: 0%, a longitudinal direction ($\Delta$S): 0%, and a contraction treatment time in a longitudinal direction: 0 second

(Thermal Relaxation Section)

Similarly to the thermal fixation zone, a film surface temperature was adjusted, and the maximum arrival film surface temperature ($T_{thermal\ relaxation}$) during thermal relaxation was adjusted to a temperature (198°C) as shown in Table 1 to be described below. In addition, relaxation treatment was performed in the transverse direction (TD) of the film in a contraction ratio as shown in Table 1 to be described below, and contraction treatment (MD contraction) was performed in the longitudinal direction (MD) of the film in a contraction ratio and a treatment time as shown in Table 1 to be described below.

In this example, in the thermal relaxation zone in which the contraction in the longitudinal direction (MD) is performed, the maximum arrival temperature of the film surface (maximum arrival film surface temperature) reached 198°C, and a time taken to reach the maximum film temperature from an exit of the stretching zone was 34 seconds. Therefore, an average rising rate was 1.8 °C/second.

<Thermal Relaxation Condition>

• Contraction Ratio

Transverse Direction ($\Delta$L): Contraction ratio (%) shown in Table 1 to be described below
Longitudinal direction ($\Delta$S): Contraction ratio (%) shown in Table 1 to be described below
Contraction treatment time in the longitudinal direction: Time [second] shown in Table 1 to be described below

Here, the transverse direction ($\Delta$L) is a contraction ratio expressed by $\Delta L = [(L2-L3)/L2] \times 100$, when the distance at an entrance of the thermal relaxation section is set to L2 and the distance at an exit of the thermal relaxation section is set to L3 with respect to a distance between clips that grip a base in a transverse direction.

• Clip Condition

Gap ratio [A/(A+B)]: Ratio shown in Table 1 to be described below
Clip length: Length [mm] shown in Table 1 to be described below

(Cooling Section)

Next, the polyester film after the thermal relaxation was cooled at a cooling temperature of 65°C.

(Recovery of Film)

After the cooling is terminated, both ends of the polyester film was trimmed by 20 cm, respectively. Then, pressing processing (knurling) was performed with respect to the both ends in a width of 10 mm, and then was wound with tension of 25 kg/m.

In this manner, a biaxially stretched PET film having the thickness of 250 $\mu$m was prepared.

- Evaluation -

Evaluation was performed with respect to the biaxially stretched PET film that was obtained, and results are shown in Table 1 to be described below.

(1) Dimensional Stability (Thermal Contraction Ratio)

Thermal contraction ratios of the biaxially stretched PET film that was obtained in the longitudinal direction (MD) and the transverse direction (TD) were measured by the following method, and the obtained results were set as an index for evaluating the dimensional stability of the biaxially stretched PET film.

Specifically, the biaxially stretched PET film was cut to prepare a specimen M having the size of 30 mm (TD) x 120 mm (MD). With respect to this specimen M, two reference lines were formed in the MD direction to be spaced from each other at the distance of 100 mm, and then this specimen was left as is in a heating oven of 150°C for 30 minutes under no tension. After being left as is, the specimen M was cooled to room temperature and then the distance between the two reference lines was measured. Here, the measured value was set to A (unit; mm), the thermal contraction ratio [%] in MD was obtained from an formula of $100\times(100-A)/100$.

In addition, separately from this, the biaxially stretched PET film was cut to prepare a specimen L having the size of 30 mm (MD) x 120 mm (TD). With respect to this specimen L, measurement was performed by the same manner as the specimen M except that two reference lines were formed in the TD direction to be spaced from each other at the distance of 100 mm, thereby obtaining the thermal contraction ratio [%] in TD.

<Evaluation Criteria>

A: Thermal contraction ratios both in MD and TD were 1% or less
B: Thermal contraction ratio in either MD or TD exceeded 1%, and thermal contraction ratios both in MD and TD were 2% or less
C: Thermal contraction ratio either MD or TD exceeded 2%, and thermal contraction ratios both in MD and TD were 3% or less
D: Thermal contraction ratio either MD or TD exceeded 3%

(2) Hydrolysis Resistance (Half-Value Period of Fracture Elongation)

The hydrolysis resistance of the biaxially stretched PET film was evaluated by using a half-value period of fracture elongation of the biaxially stretched polyester film as an index.

Specifically, the biaxially stretched PET film that was obtained was kept under environmental conditions of a temperature of 120°C and relative humidity of 100%, and a keeping time [hr], which was taken until fracture elongation (%) that was shown in the biaxially stretched PET film after being kept became 50% of fracture elongation (%) that was shown in shown in the biaxially stretched PET film before being kept, was obtained, and this keeping time was set to a half-value period of fracture elongation. In addition, the biaxially stretched PET film was cut to prepare a specimen P having the size of 1 cm x 20 cm, and the fracture elongation (%) of the biaxially stretched PET film was obtained by stretching the specimen P using a tension tester under conditions of a distance between chucks of 5 cm and 20%/minute.

As the half-value period of fracture elongation was long, the hydrolysis resistance of the biaxially stretched PET film was satisfactory.

< Evaluation Criteria >

A: Half-value period of fracture elongation exceeded 90 hrs.
B: Half-value period of fracture elongation exceeded 85 hrs. and was equal to or less than 90 hrs.
C: Half-value period of fracture elongation exceeded 80 hrs. and was equal to or less than 85 hrs.
D: Half-value period of fracture elongation was less than 80 hrs.

(3) Overall Determination

Determination was carried out based on the evaluation results of (1) to (2) using the following determination criteria.

<Determination Criteria>

A: Very good (both of the dimensional stability and the hydrolysis resistance were evaluated as "A")
B: Good (both of the dimensional stability and the hydrolysis resistance were evaluated as "B" or more)
C: No problem (both of the dimensional stability and the hydrolysis resistance were evaluated as "C" or more)
D: Problematic (both of the dimensional stability and the hydrolysis resistance were evaluated as "D")

Furthermore, a back sheet was prepared as described below by using the biaxially stretched PET film that was obtained.

<Formation of Reflective Layer>

- Preparation of Pigment Dispersion -

Components in the following composition were mixed, and the mixture was subjected to dispersion treatment for one hour using a Dynomill type disperser to prepare a pigment dispersion.

<Composition>

- Titanium dioxide (volume average particle size = 0.42 $\mu$m) $\cdots$ 39.9% by mass (trade name: TIPAQUE R-780-2, manufactured by Ishihara Sangyo Kaisha, Ltd.; solid content: 100% by mass)
- Polyvinyl alcohol $\cdots$ 8.0% by mass (trade name: PVA-105, manufactured by Kuraray Co., Ltd.; solid content: 10% by mass)
- Surfactant $\cdots$ 0.5% by mass (trade name: DEMOL EP, manufactured by Kao Corp.; solid content: 25% by mass)
- Distilled water $\cdots$ 51.6 mass%

- Preparation of Coating Liquid for Reflective Layer -

Components in the following composition were mixed to prepare a coating liquid for a reflective layer.

<Composition>

- Pigment dispersion described above $\cdots$ 80.0 parts
- Aqueous dispersion liquid of polyacrylic resin $\cdots$ 19.2 parts (binder: JURYMER ET410 (trade name), manufactured by Nihon Junyaku Co., Ltd.; solid content: 30% by mass)
- Polyoxyalkylene alkyl ether $\cdots$ 3.0 parts (trade name: NAROACTY CL95, manufactured by Sanyo Chemical Industries, Ltd.; solid content: 1% by mass)
- Oxazoline compound (crosslinking agent) $\cdots$ 2.0 parts (trade name: EPOCROS WS-700, manufactured by Nippon Shokubai Co., Ltd.; solid content: 25% by mass)
- Distilled water $\cdots$ 7.8 parts

- Formation of Reflective Layer -

The coating liquid for the reflective layer that was obtained was applied on the biaxially stretched PET film, and was dried at 180°C for one minute to form a white layer (light reflection layer) having an amount of titanium dioxide of 6.5 g/m$^2$ as a colored layer.

<Formation of Easy Adhesive Layer>

- Preparation of Coating liquid for Easy Adhesive Layer -

Components in the following composition were mixed to prepare a coating liquid for an easy adhesive layer.

<Composition>

- Aqueous dispersion liquid of polyolefin resin $\cdots$ 5.2 parts (Binder: CHEMIPEARL S-75N (trade name), manufactured by Mitsui Chemicals, Inc.; solid content: 24% by mass)
- Polyoxyalkylene alkyl ether $\cdots$ 7.8 parts (trade name: NAROACTY CL95, manufactured by Sanyo Chemical Industries, Ltd.; solid content: 1% by mass)
- Oxazoline compound (crosslinking agent) $\cdots$ 0.8 parts (trade name: EPOCROS WS-700, manufactured by Nippon Shokubai Co., Ltd.; solid content: 25% by mass)
- Aqueous dispersion of silica fine particles $\cdots$ 2.9 parts (trade name: AEROSIL OX-50, manufactured by Nippon Aerosil Co., Ltd.; volume average particle size = 0.15 μm, solid content: 10% by mass)
- Distilled water ⋯ 83.3 parts

- Formation of Easy Adhesive Layer -

The coating liquid that was obtained was applied on the light reflection layer in such a manner that an amount of binder became 0.09 g/m², and was dried at 180°C for one minute to form the easy adhesive layer.

<Back Layer>

- Preparation of Coating Liquid for Back Layer -

Components in the following composition were mixed to prepare a coating liquid for back layer.

<Composition>

- CERANATE WSA-1070 (binder) ⋯ 323 parts (acryl/silicone-based binder, manufactured by DIC Corp., solid content: 40% by mass)
- Oxazoline compound (crosslinking agent) ⋯ 52 parts (trade name: EPOCROS WS-700, manufactured by Nippon Shokubai Co., Ltd.; solid content; 25% by mass)
- Polyoxyalkylene alkyl ether (surfactant) ⋯ 32 parts (trade name: NAROACTY CL95, manufactured by Sanyo Chemical Industries, Ltd.; solid content: 1% by mass)
- Distilled water ⋯ 594 parts

- Formation of Back Layer -

The coating liquid for the back layer that was obtained was applied on the side of the biaxially stretched PET film where the reflective layer and the easy adhesive layer were not formed in such a manner that an amount of the binder was 3.0 g/m² as a wet application amount, and the coating liquid was dried at 180°C for one minute, thereby forming a back layer having a dry thickness of 3 μm.
As described above, a back sheet was produced.

(Example 2)

A biaxially stretched PET film was prepared, evaluation was carried out, and a back sheet was produced by the same manner as Example 1 except that the film forming speed in the sheet forming process, and the temperature of the heating wind, the airflow velocity, and the treatment time of MD relaxation in the transverse stretching process in Example 1 were adjusted. Evaluation results are shown in Table 1 to be described below.

(Examples 3 to 7, 11 to 13, 15 to 16, and Comparative Examples 1 to 5)

A biaxially stretched PET film was prepared, evaluation was carried out, and a back sheet was produced by the same manner as Example 1 except that IV of the non-stretched PET sheet, the thermal fixation section in the transverse stretching process, the heat treatment conditions in the thermal relaxation section, and the clip condition in Example 1 were changed as shown in Table 1 to be described below. Evaluation results are shown in Table 1 to be described below.
In addition, in regard to IV of the non-stretched PET sheet, IV of a raw material resin was adjusted by changing a solid-phase polymerization time, whereby IV of the non-stretched PET sheet, which was molded by melting the raw material resin and extruding the melted resin, was adjusted.

(Example 8)

A biaxially stretched PET film was prepared, evaluation was carried out, and a back sheet was produced by the same manner as Example 1 except that in regard to Example 1, 0.1% by mass of silica particles (an average particle size of primary particles: 0.2 μm) based on the PET resin A was added to a hopper of a single-axis kneading extruder together with the dried polyester raw material resin (PET resin A), the resultant mixture was melted, a silica particle-containing non-stretched PET sheet was obtained, and the above-described non-stretched PET sheet was substituted with the silica particle-containing non-stretched PET sheet. Evaluation results are shown in Table 1 to be described below.

(Example 9)

A biaxially stretched PET film was prepared, evaluation was carried out, and a back sheet was produced by the same manner as Example 1 except that in regard to Example 1, the melted resin that was obtained by adding the dried PET resin A to the hopper of the single-axis kneading extruder (diameter: 113 mm), and separately from this melted resin, a silica-containing melted resin that was obtained by adding a dried polyester raw material resin (PET resin A) and 0.1% by mass of silica particles (an average particle size of primary particles: 0.2 $\mu$m) based on the PET resin A to a hopper of a single-axis kneading extruder having a diameter of 40 mm were coextruded in such a manner that the melted resin was interposed between the silica-containing melted resin to form laminated three layers, whereby a non-stretched PET sheet in which the silica-containing PET resin was laminated on the front and rear surfaces the sheet of the PET resin A (silica-containing PET resin/melted resin/silica-containing PET resin) was formed. Evaluation results are shown in Table 1 to be described below.

In addition, the forming condition in the sheet forming process and the conditions in the transverse stretching process were the same as Example 1. In addition, the sheet thickness of the silica-containing PET resin was set to 3 $\mu$m and the total thickness of the three layers that were laminated was set to 250 $\mu$m.

(Examples 10 and 14, and Comparative Example 6)

A biaxially stretched PP film was prepared, evaluation was carried out, and a back sheet was produced by the same manner as Example 1 except that in regard to Example 1, "manufacturing of non-stretched polyester film" and "manufacturing of biaxially stretched polyester film" were substituted with "manufacturing of non-stretched polypropylene film" and "manufacturing of biaxially stretched polypropylene film", respectively. Evaluation results are shown in Table 1 to be described below.

<Manufacturing of Non-Stretched Polypropylene Sheet>

- Sheet Forming Process -

The polypropylene resin (PP resin) was added to a hopper of a single-axis kneading extruder having a diameter of 113 mm. The PP resin was melted at 235°C and was extruded from a die under the following extrusion conditions.

<Extrusion Condition>

The extrusion conditions of the melted resin were as follows. That is, a pressure variation was set to 1% and a temperature distribution of the melted resin was set to 2%.

Specifically, a back pressure in a barrel of the extruder was set to a pressure that is higher than an average pressure inside the barrel of the extruder by 1%, and heating was carried in a manner that a pipe temperature of the extruder was set to a temperature higher than an average temperature inside the barrel of the extruder by 2%.

The melted resin was extruded from the die to a cold casting drum and was brought into closely contact with the cold casting drum by using an air knife method. The cooling of the melted resin was performed by setting a temperature of the cold casting drum to 25°C, and the resin on the cold casting drum was peeled off from the cold casting drum by using a scrapping roll that was disposed to be opposite to the cold casting drum as a non-stretched polypropylene sheet (non-stretched PP sheet) having the thickness of 0.4 mm.

<Manufacturing of Biaxially Stretched Polypropylene Film>

The non-stretched PP sheet that was obtained was biaxially stretched by the following method in a sequential manner to prepare a biaxially stretched polypropylene film (biaxially stretched PP film) having the thickness of 100 $\mu$m.

- Longitudinal Stretching Process -

The non-stretched PP sheet was made to pass between two pairs of nip rolls in which a peripheral speed of each pair was different and was stretched in a longitudinal direction (conveyance direction) under the following conditions.
Preheating temperature: 130°C
Longitudinal stretching temperature: 150°C

Longitudinal stretching magnification: 2.0 times

- Transverse Stretching -

The longitudinally stretched PP film (longitudinally stretched PP film) was stretched by using a transverse stretching tenter under the following conditions.

(Preheating Section)

Preheating temperature was set to 110°C and heating was performed to be stretchable.

(Stretching Section)

Tension was applied to the longitudinally stretched PP film, which was preheated in a transverse direction of the film, which is orthogonal to the longitudinally stretching direction (longitudinal direction) under the following conditions to carry out the transverse stretching.
- Stretching temperature (transverse stretching temperature): 150°C
- Stretching magnification (transverse stretching magnification): 2.5 times
- Film surface temperature at an exit of a stretching zone: 150°C

(Thermal Fixation Section)

A temperature of film heating airflow in the thermal fixation zone was set, an airflow velocity was adjusted, and the maximum arrival temperature ($T_{thermal\ fixation}$) at the film surface temperature during thermal fixation was adjusted to a temperature (160°C) as shown in Table 1 to be described below, and the contraction treatment (MD contraction) in the longitudinal direction (MD direction) of a film was performed with a contraction ratio and a treatment time shown in Table 1 to be described below.

<Thermal Fixation Condition>

• Contraction ratio

Longitudinal direction ($\Delta S$): Contraction ratio [%] shown in Table 1 to be described below
Contraction treatment time in a longitudinal direction: time [second] shown in Table 1 to be described below

• Clip Conditions

Gap ratio [A/(A+B)]: Ratio shown in Table 1 to be described below
Clip length: Length [mm] shown in Table 1 to be described below

(Thermal Relaxation Section)

Similarly to the thermal fixation zone, a film surface temperature was adjusted. In addition, relaxation treatment was performed in the transverse direction (TD) of the film in a contraction ratio as shown in Table 1 to be described below, and contraction treatment (MD contraction) was performed in the longitudinal direction (MD) of the film in a contraction ratio and a treatment time as shown in Table 1 to be described below. The thermal relaxation maximum arrival temperature ($T_{thermal\ relaxation}$) was set to a temperature (162°C) shown in Table 1 to be described below.
In this example, in the thermal relaxation zone in which the contraction in the longitudinal direction (MD) is performed, the maximum arrival temperature of the film surface (maximum arrival film surface temperature) reached 162°C, and a time taken to reach the maximum film temperature from an exit of the stretching zone was 20 seconds.

<Thermal Relaxation Condition>

• Contraction Ratio

Transverse Direction ($\Delta L$): Contraction ratio (%) shown in Table 1 to be described below

Longitudinal direction (ΔS): Contraction ratio (%) shown in Table 1 to be described below
Contraction treatment time in the longitudinal direction: Time [second] shown in Table 1 to be described below

• Clip Condition

Gap ratio [A/(A+B)]: Ratio shown in Table 1 to be described below
Clip length: Length [mm] shown in Table 1 to be described below

(Cooling Section)

Next, the polypropylene film after the thermal relaxation was cooled at a cooling temperature of 50°C.

(Recovery of Film)

After the cooling is terminated, both ends of the polypropylene film was trimmed by 20 cm, respectively. Then, pressing processing (knurling) was performed with respect to the both ends in a width of 10 mm, and then was wound with tension of 5 kg/m.
In this manner, a biaxially stretched PP film having the thickness of 100 μm and the width of 120 cm was prepared.

[Table 1]

| | Sheet forming process | | Transverse stretching process | | | | | | | | Clip conditions | | Thickness of stretched film | Evaluation | | | | | Overall evaluation |
|---|---|---|---|---|---|---|---|---|---|---|---|---|---|---|---|---|---|---|---|
| | Non-stretched sheet | | Thermal fixation section | | | Thermal Relaxation section | | | | | | | | Thermal contraction ratio | | | Hydrolysis resistance | | |
| | Raw material | IV | $T_{thermal\ fixation}$ | Longitudinal direction (MD) | | $T_{thermal\ relaxation}$ | Transverse direction (TD) | Longitudinal direction (MD) | | Average rising rate on film surface | Gap ratio A/(A+B) | Clip length | | 150°C, 30 minutes | | | 120°C, 100%RH | | |
| | | | | Contraction ratio ΔS | Treatment time | | Contraction ratio ΔL | Contraction ratio ΔS | Treatment time | | | | | MD | TD | Determination | Half-value period of fracture Elongation | Determination | |
| | Kind | [°] | [°] | [%] | [sec] | [°C] | [%] | [%] | [sec] | [°C/sec] | [-] | [mm] | [μm] | [%] | [%] | | [hr] | | |
| Example 1 | PET | 0.75 | 193 | 0 | 0 | 198 | 10 | 5 | 20 | 1.8 | 0.115 | 115 | 250 | 0.1 to 0.2 | 0.1 to 0.2 | A | 100 | A | A |
| Example 2 | PET | 0.75 | 193 | 0 | 0 | 198 | 10 | 5 | 13 | 3.2 | 0.115 | 115 | 250 | 0.1 to 0.2 | 0.1 to 0.2 | A | 100 | A | A |
| Example 3 | PET | 0.75 | 193 | 2 | 9 | 197 | 5 | 3 | 11 | 1.7 | 0.115 | 120 | 245 | 0.7 to 1.1 | 0.5 to 0.6 | B | 102 | A | B |
| Example 4 | PET | 0.75 | 195 | 0 | 0 | 198 | 10 | 6 | 25 | 2.1 | 0.074 | 125 | 250 | 0.2 to 0.3 | 0.1 to 0.2 | A | 102 | A | A |
| Example 5 | PET | 0.80 | 195 | 2 | 10 | 208 | 5 | 3 | 20 | 0.9 | 0.080 | 115 | 250 | 0.3 to 0.5 | 0.2 to 0.4 | A | 83 | C | C |
| Example 6 | PET | 0.80 | 190 | 2 | 10 | 190 | 5 | 3 | 20 | 3.3 | 0.080 | 115 | 240 | 0.3 to 0.5 | 0.3 to 0.4 | A | 105 | A | A |
| Example 7 | PET | 0.75 | 160 | 0 | 0 | 165 | 10 | 5 | 20 | 1.8 | 0.115 | 115 | 235 | 1.5 to 2.1 | 0.4 to 0.7 | C | 110 | A | C |
| Example 8 | PET +Silica | 0.75 | 193 | 0 | 0 | 198 | 10 | 5 | 20 | 1.8 | 0.115 | 115 | 250 | 0.3 to 0.4 | 0.2 to 0.3 | A | 98 | A | A |
| Example 9 | Laminate of PET sheet/silica-containing sheet | 0.75 | 193 | 0 | 0 | 198 | 10 | 5 | 20 | 1.8 | 0.115 | 115 | 250 | 0.1 to 0.3 | 0.1 to 0.2 | A | 100 | A | A |
| Example 10 | PP | - | 160 | 0 | 0 | 162 | 5 | 5 | 15 | 0.6 | 0.107 | 125 | 100 | 0.2 to 0.3 | 0.2 to 0.3 | A | - | - | - |
| Example 11 | PET | 0.75 | 193 | 0 | 0 | 198 | 10 | 5 | 25 | 0.8 | 0.161 | 115 | 250 | 0.8 to 2.3 | 0.1 to 0.4 | C | 95 | A | C |
| Example 12 | PET | 0.75 | 190 | 0 | 0 | 190 | 10 | 5 | 25 | 1.8 | 0.057 | 165 | 250 | 0.2 to 2.2 | 0.1 to 0.4 | C | 98 | A | C |
| Example 13 | PET | 0.75 | 190 | 0 | 0 | 190 | 10 | 5 | 20 | 1.8 | 0.091 | 95 | 250 | 0.2 to 0.3 | 1.1 to 2.2 | C | 103 | A | C |
| Example 14 | PP | - | 160 | 0 | 0 | 162 | 5 | 5 | 15 | 0.6 | 0.057 | 165 | 100 | 0.2 to 2.2 | 0.4 to 0.6 | C | - | - | - |
| Example 15 | PET | 0.75 | 188 | 0 | 0 | 190 | 7 | 6 | 56 | 0.8 | 0.115 | 115 | 250 | 0.1 to 0.2 | 0.1 to 0.2 | A | 99 | A | A |
| Example 16 | PET | 0.75 | 195 | 2 | 10 | 208 | 10 | 5 | 30 | 4.1 | 0.115 | 115 | 250 | 0.4 to 0.5 | 0.1 to 0.2 | A | 86 | B | B |
| Comparative Example 1 | PET | 0.75 | 193 | 0 | 0 | 198 | 10 | 2 | 20 | 1.8 | 0.115 | 115 | 250 | 2.2 to 2.5 | 0.5 to 0.6 | C | 102 | A | C |

EP 2 570 252 B1

| Comparative Example 2 | PET | 0.80 | 193 | 0 | 0 | 198 | 10 | 10 | 20 | 1.8 | 0.115 | 115 | 250 | 0.3 to 2.1 | 0.2 to 0.3 | C | 88 | B | C |
|---|---|---|---|---|---|---|---|---|---|---|---|---|---|---|---|---|---|---|---|
| Comparative Example 3 | PET | 0.75 | 190 | 0 | 0 | 190 | 10 | 5 | 5 | 1.8 | 0.115 | 115 | 250 | 2.5 to 3.2 | 0.4 to 0.5 | D | 82 | C | D |
| Comparative Example 4 | PET | 0.75 | 195 | 0 | 0 | 198 | 10 | 5 | 70 | 0.5 | 0.115 | 115 | 250 | 0.1 to 0.2 | 0.1 to 0.2 | A | 77 | D | D |
| Comparative Example 5 | PET | 0.75 | 225 | 0 | 0 | 235 | 10 | 5 | 20 | 5.5 | 0.115 | 115 | 250 | 0.1 to 0.2 | 0.1 to 0.2 | A | 60 | D | D |
| Comparative Example 6 | PP | - | 160 | 0 | 0 | 162 | 5 | 2 | 5 | 0.6 | 0.107 | 125 | 100 | 1.6 to 2.3 | 0.4 to 0.8 | C | - | - | - |

35

As shown in Table 1, in examples, the thermal contraction ratio was suppressed to be small, and thus the dimensional stability was satisfactory and the hydrolysis resistance was excellent.

On the contrary to this, in comparative examples, even when the hydrolysis resistance was maintained to some degree, but the dimensional stability was poor. Conversely, even when the thermal contraction was suppressed to be small, but the hydrolysis resistance was not maintained, and thus compatibility between the dimensional stability and the hydrolysis resistance was difficult.

(Example 17)

Reinforced glass having the thickness of 3 mm, an EVA sheet (trade name: SC50B, manufactured by Mitsui Chemical Fabro Inc.), a crystalline solar cell, an EVA sheet (trade name: SC50B, manufactured by Mitsui Chemical Fabro Inc.), and the back sheet manufactured in Examples 1 to 16 were superimposed in this order, and were subjected to hot pressing by using a vacuum laminator (vacuum laminating machine manufactured by Nisshinbo Holdings Inc.) so as to realize adhesion with the EVA, whereby a crystalline solar cell module was prepared. At this time, the back sheet was disposed in such a manner that the easy adhesive layer came into contact with the EVA sheet and the adhesion was performed by the following method.

<Adhesion Method>

After vacuuming was performed by using the vacuum laminator at 128°C for three minutes, pressing was performed for two minutes to carry out temporary adhesion. Then, present adhesion was performed using a dry oven at 150°C for 30 minutes.

The solar cell module manufactured as described was operated for power generation, and this solar cell module exhibited satisfactory power generation performance as a solar cell.

The biaxially stretched thermoplastic resin film (particularly, a polyester film) is appropriate for a use such as a rear surface protecting sheet (so-called back sheet) that is disposed at a rear surface that is opposite to a solar light incident side of a solar cell power generation module, a barrier film base material, and the like.

**Claims**

1. A method of manufacturing a biaxially stretched thermoplastic resin film, the method comprising:

   performing melt extrusion of a thermoplastic resin into a sheet form and cooling the resultant sheet on a casting drum to form a thermoplastic resin sheet;
   longitudinally stretching the thermoplastic resin sheet, which is formed, in a longitudinal direction or a rolling direction of the casting drum; and
   gripping the thermoplastic resin sheet after the longitudinal stretching by a gripping member and transversely stretching the thermoplastic resin sheet in a transverse direction orthogonal to the longitudinal direction,
   wherein the transverse stretching includes,
   preheating the thermoplastic resin sheet after the longitudinal stretching to a stretchable temperature,
   applying a tension to the thermoplastic resin sheet, which is preheated, in the transverse direction orthogonal to the longitudinal direction to transversely stretch the thermoplastic resin sheet,
   heating the thermoplastic resin film that is obtained by the longitudinal stretching and the transverse stretching to crystallize and thermally fix the thermoplastic resin film,
   relaxing the tension applied to the thermoplastic resin film that is thermally fixed to remove remaining strain, and cooling the thermoplastic resin film after the relaxing of the tension,
   wherein at least one of the thermal fixing and the thermal relaxing performs contraction treatment of the thermoplastic resin film in the longitudinal direction of the film in such a manner that a contraction ratio expressed by the following Formula (1) is within a range of 3 to 8% while narrowing a grip distance between gripping members adjacent to each other,
   a total contraction treatment time in the thermal fixing and the thermal relaxing is 10 to 60 seconds, and
   an average rising rate of the film surface temperature from a termination point of time of the transverse stretching in the stretching of the film until the film surface temperature reaches a maximum arrival temperature in an interval in which the contraction treatment is performed so as to satisfy the contraction ratio being set to a range of 0.6 to 4.5 °C/second,

$$[\{(A+B)-(C+B)\}/(A+B)]\times 100 \cdots \text{Formula (1)}$$

wherein in Formula (1), A represents a grip distance (mm) before narrowing the distance between the gripping members adjacent to each other, B represents the length (mm) of each of the gripping members in the longitudinal direction of the film, and C represents a grip distance (mm) after narrowing the distance between the gripping members adjacent to each other.

2. The method of manufacturing a biaxially stretched thermoplastic resin film according to claim 1, wherein the length B of the gripping member and the grip distance A before narrowing the distance between the gripping members adjacent to each other satisfy a relational formula expressed by the following Formula (2),

$$0.06 \leq A/(A+B) \leq 0.15 \cdots \text{Formula (2)}.$$

3. The method of manufacturing a biaxially stretched thermoplastic resin film according to claim 1 or 2, wherein the length B of the gripping member is 100 to 140 mm.

4. The method of manufacturing a biaxially stretched thermoplastic resin film according to any one of claims 1 to 3, wherein in at least one of the thermal fixing and the thermal relaxing, the maximum arrival temperature of the film surface is controlled to be within a range of 160 to 210°C.

5. The method of manufacturing a biaxially stretched thermoplastic resin film according to any one of claims 1 to 4, wherein the thermoplastic resin contains polyethylene terephthalate, and the thermoplastic resin film is a polyester film containing polyethylene terephthalate.

6. The method of manufacturing a biaxially stretched thermoplastic resin film according to any one of claims 1 to 5, wherein the thickness of the thermoplastic resin film after the transverse stretching is 180 to 400 $\mu$m.

**Patentansprüche**

1. Verfahren zur Herstellung einer biaxial gestreckten thermoplastischen Harzfolie, wobei das Verfahren umfasst:

Durchführen von Schmelzextrusion eines thermoplastischen Harzes in eine Bahnform und Kühlen der resultierenden Bahn auf einer Gießwalze, um eine thermoplastische Harzbahn zu bilden;
longitudinales Strecken der thermoplastischen Harzbahn, die gebildet ist, in longitudinaler Richtung oder Walzrichtung der Gießwalze; und
Greifen der thermoplastischen Harzbahn nach dem longitudinalen Strecken durch ein Greifelement und transversales Strecken der thermoplastischen Harzbahn in transversaler Richtung orthogonal zu der longitudinalen Richtung,
worin das transversale Strecken beinhaltet:

Vorerhitzen der thermoplastischen Harzbahn nach dem longitudinalen Strecken auf eine Temperatur zum Strecken,
Anlegen einer Zugspannung an die thermoplastische Harzbahn, die vorerhitzt ist, in transversaler Richtung orthogonal zu der longitudinalen Richtung, um die thermoplastische Harzbahn transversal zu strecken,
Erhitzen der thermoplastischen Harzfolie, die durch das longitudinale Strecken und das transversale Strecken erhalten wird, um die thermoplastische Harzfolie zu kristallisieren und thermisch zu fixieren,
Lockern der Zugspannung, die an die thermoplastische Harzfolie, die thermisch fixiert ist, angelegt ist, um verbleibende Spannung zu entfernen, und
Abkühlen der thermoplastischen Harzfolie nach dem Lockern der Zugspannung,
worin zumindest eines des thermischen Fixierens und des thermischen Lockerns eine Kontraktionsbehandlung der thermoplastischen Harzfolie in longitudinaler Richtung der Folie in der Art ausführt, dass ein Kontraktionsverhältnis, das durch die folgende Formel (1) ausgedrückt wird, innerhalb eines Bereichs von 3 bis 8 % liegt, während die Greifentfernung zwischen zueinander benachbarten Greifelementen verringert wird,

eine Gesamtdauer der Kontraktionsbehandlung beim thermischen Fixieren und thermischen Lockern 10 bis 60 Sekunden beträgt und

eine durchschnittliche Erhöhungsrate der Folienoberflächentemperatur ab einem Beendigungszeitpunkt des transversalen Streckens bei der Streckung der Folie bis die Folienoberflächentemperatur eine maximale Endtemperatur in einem Intervall erreicht, in dem die Kontraktionsbehandlung ausgeführt wird, um das Kontraktionsverhältnis zu erfüllen, auf einen Bereich von 0,6 bis 4,5°C/Sekunde festgesetzt wird,

$$[\{(A + B) - (C + B)\}/(A + B)] \times 100 \qquad \text{Formel (1)}$$

worin in Formel (1) A die Greifentfernung (mm) vor dem Verringern der Entfernung zwischen den zueinander benachbarten Greifelementen darstellt, B die Länge (mm) von jedem der Greifelemente in der longitudinalen Richtung der Folie darstellt und C eine Greifentfernung (mm) nach dem Verringern der Entfernung zwischen den zueinander benachbarten Greifelementen darstellt.

2. Verfahren zur Herstellung einer biaxial gestreckten thermoplastischen Harzfolie gemäß Anspruch 1, worin die Länge B des Greifelements und die Greifentfernung A vor dem Verringern der Entfernung zwischen den zueinander benachbarten Greifelementen eine durch die folgende Formel (2) ausgedrückte Verhältnisformel erfüllen

$$0,06 \leq A/(A+B) \leq 0,15 \qquad \text{Formel (2)}.$$

3. Verfahren zur Herstellung einer biaxial gestreckten thermoplastischen Harzfolie gemäß Anspruch 1 oder 2, worin die Länge B des Greifelements 100 bis 140 mm beträgt.

4. Verfahren zur Herstellung einer biaxial gestreckten thermoplastischen Harzfolie gemäß einem der Ansprüche 1 bis 3, worin in zumindest einem des thermischen Fixierens und des thermischen Lockerns die maximale Endtemperatur der Folienoberfläche innerhalb eines Bereichs von 160 bis 210°C gehalten wird.

5. Verfahren zur Herstellung einer biaxial gestreckten thermoplastischen Harzfolie gemäß einem der Ansprüche 1 bis 4, worin das thermoplastische Harz Polyethylenterephthalat enthält und die thermoplastische Harzfolie eine Polyethylenterephthalat enthaltende Polyesterfolie ist.

6. Verfahren zur Herstellung einer biaxial gestreckten thermoplastischen Harzfolie gemäß einem der Ansprüche 1 bis 5, worin die Dicke der thermoplastischen Harzfolie nach dem transversalen Strecken 180 bis 400 $\mu$m beträgt.

**Revendications**

1. Procédé de fabrication d'un film de résine thermoplastique étiré de manière biaxiale, le procédé comprenant le fait :

d'effectuer une extrusion à l'état fondu d'une résine thermoplastique en une forme de feuille et de refroidir la feuille résultante sur un tambour de coulage pour former une feuille de résine thermoplastique ;

d'étirer longitudinalement la feuille de résine thermoplastique, qui est formée, dans une direction longitudinale ou une direction de laminage du tambour de coulage ; et

de saisir la feuille de résine thermoplastique après l'étirage longitudinal par un élément de préhension et d'étirer transversalement la feuille de résine thermoplastique dans une direction transversale orthogonale à la direction longitudinale,

dans lequel l'étirage transversal comporte le fait,

de préchauffer la feuille de résine thermoplastique après l'étirage longitudinal à une température d'étirage,

d'appliquer une tension à la feuille de résine thermoplastique, qui est préchauffée, dans la direction transversale orthogonale à la direction longitudinale pour étirer transversalement la feuille de résine thermoplastique,

de chauffer le film de résine thermoplastique qui est obtenu par l'étirage longitudinal et l'étirage transversal pour cristalliser et fixer thermiquement le film de résine thermoplastique,

de relâcher la tension appliquée sur le film de résine thermoplastique qui est fixé thermiquement pour éliminer les contraintes restantes, et

de refroidir le film de résine thermoplastique après le relâchement de la tension,

dans lequel au moins une étape parmi la fixation thermique et le relâchement thermique effectue un traitement de contraction du film de résine thermoplastique dans la direction longitudinale du film de manière à ce qu'un rapport de contraction exprimé par la formule suivante (1) soit situé à l'intérieur d'une plage allant de 3 à 8% tout en rétrécissant une distance de préhension entre des éléments de préhension adjacents l'un à l'autre,

un temps de traitement de contraction total dans la fixation thermique et le relâchement thermique est compris entre 10 et 60 secondes, et

un taux d'augmentation moyen de la température de surface de film à partir d'un point de fin du temps de l'étirage transversal dans l'étirage du film jusqu'à ce que la température de surface de film atteigne une température d'arrivée au maximum dans un intervalle dans lequel le traitement de contraction est effectué de manière à satisfaire le rapport de contraction étant fixé à une plage allant de 0,6 à 4,5°C/seconde,

$$[\{(A+B)-(C+B)\}/(A+B)]\times100 \ldots \text{Formule (1)}$$

où, dans la Formule (1), A représente une distance de préhension (mm) avant rétrécissement de la distance entre les éléments de préhension adjacents l'un à l'autre, B représente la longueur (mm) de chacun des éléments de préhension dans la direction longitudinale du film, et C représente une distance de préhension (mm) après rétrécissement de la distance entre les éléments de préhension adjacents l'un à l'autre

2. Procédé de fabrication d'un film de résine thermoplastique étiré de manière biaxiale selon la revendication 1, dans lequel la longueur B de l'élément de préhension et la distance de préhension A avant rétrécissement de la distance entre les éléments de préhension adjacents l'un à l'autre satisfont une formule relationnelle exprimée par la formule suivante (2),

$$0,06 \leq A/(A+B) \leq 0,15 \ldots \text{Formule (2).}$$

3. Procédé de fabrication d'un film de résine thermoplastique étiré de manière biaxiale selon la revendication 1 ou 2, dans lequel la longueur B de l'élément de préhension est comprise entre 100 et 140 mm.

4. Procédé de fabrication d'un film de résine thermoplastique étiré de manière biaxiale selon l'une quelconque des revendications 1 à 3, dans lequel dans au moins une étape parmi la fixation thermique et le relâchement thermique, la température d'arrivée au maximum de la surface de film est régulée de manière à être située à l'intérieur d'une plage allant de 160 à 210°C.

5. Procédé de fabrication d'un film de résine thermoplastique étiré de manière biaxiale selon l'une quelconque des revendications 1 à 4, dans lequel la résine thermoplastique contient du polyéthylène téréphtalate, et le film de résine thermoplastique est un film de polyester contenant du polyéthylène téréphtalate.

6. Procédé de fabrication d'un film de résine thermoplastique étiré de manière biaxiale selon l'une quelconque des revendications 1 à 5, dans lequel l'épaisseur du film de résine thermoplastique après l'étirage transversal est comprise entre 180 et 400 μm.

FIG. 1

FIG. 2A

FIG. 2B

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2004130594 A
- JP 2001212919 A
- JP 2007276190 A
- JP 6023838 A
- JP H06023838 A
- JP 2010240976 A
- WO 2002022707 A
- US 2010256261 A1
- JP 2007035694 A
- JP 2008028294 A
- WO 2007063698 A